# EUROPEAN PATENT APPLICATION

(11) **EP 4 568 105 A1**
(43) Date of publication of application: **11.06.2025**
(21) Application number: 23871979.3
(22) Date of filing: 14.09.2023
(51) Int. Cl.: H03F 1/02, H03F 3/24, H04B 1/04

(54) **TRACKER CIRCUIT, HIGH FREQUENCY COMMUNICATION SYSTEM, AND TRACKING METHOD**

(30) Priority: 29.09.2022 JP 2022155822
(71) Applicant: Murata Manufacturing Co., Ltd., Nagaokakyo-shi, Kyoto 617-8555 (JP)
(72) Inventor: KOGURE, Takeshi, Nagaokakyo-shi, Kyoto 617-8555 (JP); KATO, Muneharu, Nagaokakyo-shi, Kyoto 617-8555 (JP); MATSUI, Toshiki, Nagaokakyo-shi, Kyoto 617-8555 (JP)
(74) Representative: Stöckeler, Ferdinand
(86) International application number: PCT/JP2023/033623
(87) International publication number: WO 2024/070746

(57) **Abstract**

A tracker circuit (1A) is a tracker circuit (1A) connected to a pre-regulator circuit (11) configured to convert an input voltage to a regulating voltage, including: a switched-capacitor circuit (20) configured to generate a plurality of discrete voltages based on the regulating voltage; and a supply modulator (31) configured to selectively output at least one of the plurality of discrete voltages to a power amplifier (2A), in which the pre-regulator circuit (11) is configured to output the regulating voltage to the switched-capacitor circuit (20), and to output the regulating voltage to a power amplifier (2B) without passing through the switched-capacitor circuit (20).

## Description

### Technical Field

The present invention relates to a tracker circuit, a radio frequency communication system, and a tracking method.

### Background Art

The recent application of an envelope tracking (ET) mode to a power amplifier (PA) circuit has led to the improvement of power-added efficiency (PAE). Patent Document 1 discloses a technique related to a digital ET mode for supplying a plurality of discrete voltages.

### Citation List

### Patent Document

Patent Document 1: U.S. Patent No. 9,755,672

### Summary of Invention

### Technical Problem

However, the above technique of the related art can result in reduced power-added efficiency.

The present invention therefore provides a tracker circuit, a radio frequency communication system, and a tracking method that can improve power-added efficiency. Solution to Problem

A tracker circuit according to one aspect of the present invention is a tracker circuit connected to a first converter circuit configured to convert an input voltage to a first regulating voltage, including: a second converter circuit configured to generate a plurality of discrete voltages based on the first regulating voltage; and a first supply modulator configured to selectively output at least one of the plurality of discrete voltages to a first power amplifier, in which the first converter circuit is configured to output the first regulating voltage to the second converter circuit, and to output the first regulating voltage to a second power amplifier without passing through the second converter circuit.

A tracker circuit according to one aspect of the present invention includes: a first external connection terminal connected to a first pre-regulator circuit including a first power inductor; a second external connection terminal connected to a first power amplifier; a switched-capacitor circuit including a first input terminal and a plurality of first output terminals, the first input terminal being connected to the first external connection terminal; and a first supply modulator including a plurality of second input terminals and a second output terminal, the plurality of second input terminals being connected to the plurality of first output terminals, the second output terminal being connected to the second external connection terminal, in which the first pre-regulator circuit is further connected to a second power amplifier without passing through the switched-capacitor circuit and the first supply modulator.

A radio frequency communication system according to one aspect of the present invention includes the tracker circuit, the first converter circuit, the first power amplifier, and the second power amplifier.

A tracking method according to one aspect of the present invention includes: converting an input voltage to a regulating voltage using a power inductor; generating a plurality of discrete voltages based on the regulating voltage; selectively supplying at least one of the plurality of discrete voltages to a first power amplifier; and supplying the regulating voltage to a second power amplifier after skipping generation of the plurality of discrete voltages.

### Advantageous Effects of Invention

A tracker circuit and the like according to an aspect of the present invention can improve the power-added efficiency.

### Brief Description of Drawings

[Fig. 1A] Fig. 1A is a graph illustrating an example of transition of a power supply voltage in an average power tracking (APT) mode.
[Fig. 1B] Fig 1B is a graph illustrating an example of transition of a power supply voltage in an analog envelope tracking (A-ET) mode.
[Fig. 1C] Fig. 1C is a graph illustrating an example of transition of a power supply voltage in a digital envelope tracking (D-ET) mode.
[Fig. 2] Fig. 2 is a circuit configuration diagram of a communication device according to Embodiment 1.
[Fig. 3] Fig. 3 is a circuit configuration diagram of a switched-capacitor circuit, a supply modulator, and a filter circuit, which are included in a tracker circuit according to Embodiment 1, and a pre-regulator circuit.
[Fig. 4] Fig. 4 is a circuit configuration diagram of a digital control circuit included in the tracker circuit according to Embodiment 1.
[Fig. 5] Fig. 5 is a flowchart illustrating a tracking method according to Embodiment 1.
[Fig. 6] Fig. 6 is a plan view of a tracker module according to Embodiment 1.
[Fig. 7] Fig. 7 is a plan view of the tracker module according to Embodiment 1.
[Fig. 8] Fig. 8 is a cross-sectional view of the tracker module according to Embodiment 1.
[Fig. 9] Fig. 9 is a layout diagram of modules in the communication device according to Embodiment 1.
[Fig. 10] Fig. 10 is a circuit configuration diagram of a communication device according to Embodiment 2.
[Fig. 11] Fig. 11 is a circuit configuration diagram of a communication device according to Embodiment 3.
[Fig. 12] Fig. 12 is a partial circuit configuration diagram of a communication device according to another embodiment.

### Description of Embodiments

Hereinafter, embodiments of the present invention will be described in detail with reference to the drawings. Note that the embodiments described below are all comprehensive or specific examples. The numerical values, shapes, materials, components, arrangements and connection forms of the components, and the like described in the following embodiments are merely examples and are not intended to limit the present invention.

Note that each drawing is a schematic diagram that is not necessarily strictly illustrated, in which some components are highlighted or omitted, or ratios are adjusted as necessary to illustrate the present invention. The shapes, positional relationships, and ratios may differ from actual ones. In each drawing, substantially the same configurations are denoted by the same reference numerals, and repetitive description may be omitted or simplified.

In the following drawings, an x-axis and a y-axis are orthogonal to each other on a plane parallel to a main surface of a module laminate. Specifically, when the module laminate has a rectangular shape in plan view, the x-axis is parallel to the first side of the module laminate, and the y-axis is parallel to the second side of the module laminate that is orthogonal to the first side. A z-axis is perpendicular to the main surface of the module laminate, with its positive direction indicating an upward direction and its negative direction indicating a downward direction.

In a circuit configuration of the present invention, "connected" includes not only direct connection by a connection terminal and/or wiring conductor, but also electrical connection through other circuit elements. "Directly connected" means direct connection by a connection terminal and/or wiring conductor without any other circuit elements. "Connected between A and B" means connection to both A and B between A and B, and means series connection to a path between A and B. The "path between A and B" means a path formed by a conductor that electrically connects A to B. "Connected in series to a path" means series connection to a path, and means connection between one end of the path and the other end of the path. "Connected in shunt with a path" means connection between the path and ground.

In the component arrangement of the present invention, "a component is disposed on a laminate" includes the arrangement of the component on the main surface of the laminate and arrangement of the component within the laminate. "A component is disposed on the main surface of the laminate" includes the arrangement of the component in contact with the main surface of the laminate, as well as the arrangement of the component above the main surface with the component not in contact with the main surface (for example, laminating the component on another component disposed in contact with the main surface). "A component is disposed on the main surface of the laminate" may also include the arrangement of the component in a recess formed in the main surface. "A component is disposed within the laminate" includes encapsulation of the component within the module laminate, as well as the arrangement of the entire component between both main surfaces of the laminate with the component partially not covered with the laminate, and the arrangement of only a part of the component within the laminate.

In the component arrangement of the present invention, "plan view of the module laminate" means an orthographically projected view of an object on the xy plane from the positive side of the z-axis. "A overlaps with B in plan view" means that at least a part of a region of A orthographically projected onto the xy plane overlaps with at least a part of a region of B orthographically projected onto the xy plane. "A is disposed between B and C" means that at least one of a plurality of line segments connecting any point in B and any point in C passes through A.

In the component arrangement of the present invention, "A is disposed adjacent to B" means that A and B are disposed in close proximity to each other, and specifically, that no other circuit components exist in the space where A faces B. In other words, "A is disposed adjacent to B" means that none of a plurality of line segments that reach B from any point on the surface of A facing B along the normal direction of the surface passes through circuit components other than A and B. Here, the circuit components refer to components including active elements and/or passive elements. More specifically, circuit components include an active component such as a transistor or a diode, and a passive component such as an inductor, a transformer, a capacitor, or a resistor, but do not include electromechanical components such as a terminal, a connector, or wiring. The distance between two objects means the shortest distance between the two objects. Specifically, the distance between two objects means the length of the shortest line segment among a plurality of line segments connecting any point on one of the two objects to any point on the other of the two objects.

In the present invention, the term "terminal" means a point at which a conductor in an element ends. Note that, when the impedance of a conductor between elements is sufficiently low, a terminal is interpreted not only as a single point, but also as any point on the conductor between the elements or the entire conductor.

The terms indicating the relationship between elements, such as "parallel" and "perpendicular", the term indicating the shape of the element, such as "rectangular", and numerical ranges do not only represent strict meanings, but also include substantially the same ranges, for example, errors of about several percent.

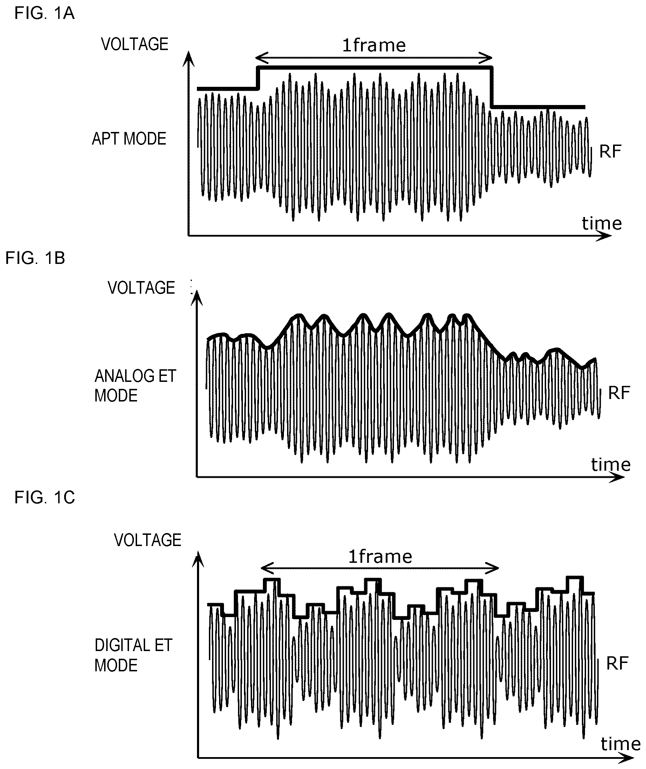

First, as a technique to amplify a radio frequency (RF) signal with high efficiency, a tracking mode will be described, which supplies a power amplifier with a power supply voltage that is dynamically regulated over time based on the RF signal. The tracking mode is a mode for dynamically regulating the power supply voltage applied to the power amplifier. While there are several types of tracking modes, an APT mode and an ET mode (including an analog ET mode and a digital ET mode) will be described here with reference to Figs. 1A to 1C. In Figs. 1A to 1C, the horizontal axis represents time and the vertical axis represents voltage. The thick solid line represents the power supply voltage, and the thin solid line (waveform) represents a modulated signal.

Fig. 1A is a graph illustrating an example of the transition of the power supply voltage in the APT mode. In the APT mode, the power supply voltage is changed to a plurality of discrete voltage levels in unit of a frame based on the average power. As a result, a power supply voltage signal forms a rectangular wave.

A frame is a unit that constitutes an RF signal (modulated signal). In 5GNR (5th Generation New Radio) and LTE (Long Term Evolution), for example, a frame includes ten subframes, each subframe includes a plurality of slots, and each slot includes a plurality of symbols. The subframe length is 1 ms, and the frame length is 10 ms.

Note that a mode in which the voltage level is changed in unit of a frame or larger based on the average power is called the APT mode, and is distinguished from a mode in which the voltage level is changed in unit smaller than one frame (for example, a subframe, slot or symbol). For example, a mode in which the voltage level is changed in unit of a symbol is called a symbol power tracking (SPT) mode, and is distinguished from the APT mode.

Fig. 1B is a graph illustrating an example of the transition of the power supply voltage in the analog ET mode. In the analog ET mode, the envelope of the modulated signal is tracked by continuously changing the power supply voltage based on an envelope signal.

The envelope signal is a signal indicating the envelope of a modulated signal. An envelope value is expressed by the square root of (I²+Q²), for example. Here, (I, Q) represents a constellation point. The constellation point is a point that represents a signal modulated by digital modulation on a constellation diagram. (I, Q) is determined by a baseband integrated circuit (BBIC), for example, based on transmission information, for example.

Fig. 1C is a graph illustrating an example of the transition of the power supply voltage in the digital ET mode. In the digital ET mode, the envelope of a modulated signal is tracked by changing the power supply voltage to a plurality of discrete voltage levels within one frame, based on an envelope signal. As a result, a power supply voltage signal forms a rectangular wave.

### (Embodiment 1)

Embodiment 1 will be described below. A communication device 7A according to this embodiment is an example of a radio frequency communication system, and corresponds to a user equipment (UE) in a cellular network, typically a mobile phone, a smartphone, a tablet computer, a wearable device or the like. The communication device 7A may be an IoT (Internet of Things) sensor device, a medical/healthcare device, a car, an unmanned aerial vehicle (UAV) (so-called drone) or an automated guided vehicle (AGV). The communication device 7A may also function as a base station (BS) in the cellular network.

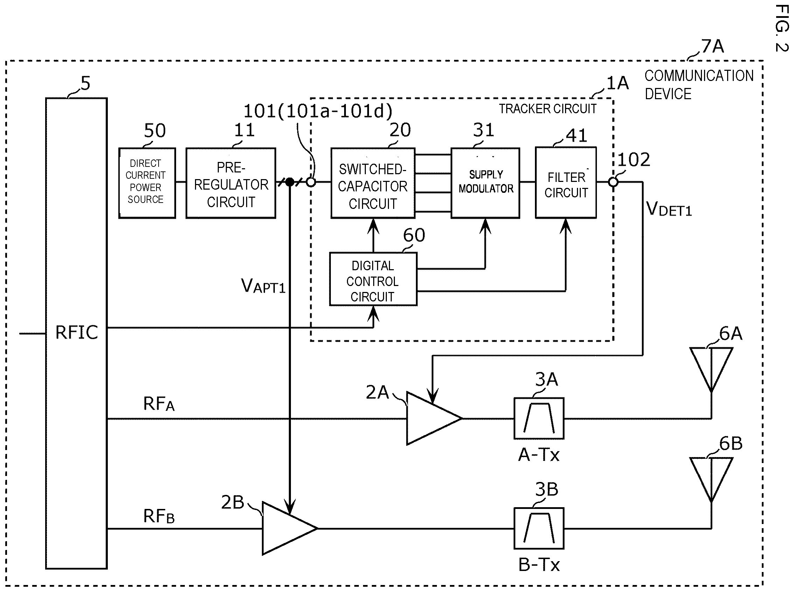

A circuit configuration of the communication device 7A and a tracker circuit 1A according to this embodiment will be described with reference to Fig. 2. Fig. 2 is a circuit configuration diagram of the communication device 7A according to this embodiment.

Fig. 2 illustrates an exemplary circuit configuration, and the communication device 7A and the tracker circuit 1A can be implemented using any of a wide variety of circuit implementations and circuit techniques. Therefore, the description of the communication device 7A and the tracker circuit 1A provided below should not be interpreted as being limited thereto.

### [1.1 Circuit Configuration of Communication Device 7A]

First, the communication device 7A according to this embodiment will be described with reference to Fig. **2****.** The communication device 7A includes the tracker circuit 1A, power amplifiers 2A and 2B, filters 3A and 3B, a radio frequency integrated circuit (RFIC) 5, antennas 6A and 6B, a pre-regulator circuit 11, and a direct current (DC) power source 50.

The tracker circuit 1A can supply a power supply voltage V_{DET1} to the power amplifier 2A based on the digital ET mode. Note that a symbol power tracking (SPT) mode or the like may be used instead of the digital ET mode.

As illustrated in Fig. 2, the tracker circuit 1A includes a switched-capacitor circuit 20, a supply modulator 31, a filter circuit 41, a digital control circuit 60, and external connection terminals 101a to 101d and 102.

The external connection terminals 101a to 101d are each an example of a first external connection terminal for receiving a regulating voltage (an example of a first regulating voltage) from the pre-regulator circuit 11. The external connection terminals 101a to 101d are each connected to the pre-regulator circuit 11 outside the tracker circuit 1A, and connected to the switched-capacitor circuit 20 inside the tracker circuit 1A. Note that the tracker circuit 1A may include at least one of the external connection terminals 101a to 101d, and does not necessarily need to include all of the external connection terminals 101a to 101d. Hereinafter, the external connection terminals 101a to 101d may be referred to as external connection terminals 101 unless necessary to distinguish them from each other.

The external connection terminal 102 is an example of a second external connection terminal, which is connected to the power amplifier 2A outside the tracker circuit 1A and connected to the filter circuit 41 inside the tracker circuit 1A. The external connection terminal 102 is a terminal for supplying the power supply voltage V_{DET1} to the power amplifier 2A.

The switched-capacitor circuit 20 is an example of a second converter circuit, which includes a plurality of capacitors and a plurality of switches. The switched-capacitor circuit 20 can generate a plurality of discrete voltages, each having a plurality of discrete voltage levels, based on the regulating voltage received from the pre-regulator circuit 11. The switched-capacitor circuit 20 may also be referred to as a switched-capacitor voltage balancer.

The supply modulator 31 is an example of a first supply modulator, which is configured to selectively output at least one of the plurality of discrete voltages generated by the switched-capacitor circuit 20 to the power amplifier 2A. Specifically, the supply modulator 31 can select at least one voltage from among the plurality of discrete voltages and output the selected at least one voltage to the power amplifier 2A. In this event, the supply modulator 31 can discretely change over time the level of the voltage outputted to the power amplifier 2A by repeating the selection operation. Such a supply modulator 31 is controlled based on a digital control signal.

The filter circuit 41 is connected between the supply modulator 31 and the power amplifier 2A, and is configured to attenuate noise components from signals (a plurality of discrete voltages) from the supply modulator 31.

The digital control circuit 60 can control the pre-regulator circuit 11, the switched-capacitor circuit 20, the supply modulator 31, and the filter circuit 41, based on a digital control signal from the RFIC 5.

The tracker circuit 1A does not have to include at least one of the switched-capacitor circuit 20, the supply modulator 31, the filter circuit 41, and the digital control circuit 60. For example, the tracker circuit 1A does not have to include the digital control circuit 60. Any combination of the switched-capacitor circuit 20, the supply modulator 31, and the filter circuit 41 may be integrated into a single circuit.

The pre-regulator circuit 11 is an example of a first converter circuit and a first pre-regulator circuit, which is configured to convert an input voltage into a regulating voltage. The pre-regulator circuit 11 can output the regulating voltage to the switched-capacitor circuit 20, and can also output the regulating voltage to the power amplifier 2B without passing through the switched-capacitor circuit 20. Specifically, the pre-regulator circuit 11 includes a power inductor and a switch. The power inductor is an inductor used to raise and/or lower a direct current (DC) voltage. The power inductor is connected in series to a direct current (DC) path. The power inductor may also be connected in shunt with a series path. Such a pre-regulator circuit 11 may also be referred to as a magnetic regulator or a DC-to-DC converter.

The DC power source 50 can supply a DC voltage to the pre-regulator circuit 11. The DC power source 50 may be, for example, a rechargeable battery, but the present invention is not limited thereto.

The power amplifier 2A is an example of a first power amplifier, which is connected between the RFIC 5 and the filter 3A. The power amplifier 2A is also connected to the tracker circuit 1A and can receive the power supply voltage V_{DET1} based on the digital ET mode. The power amplifier 2A can use the power supply voltage V_{DET1} received from the tracker circuit 1A to amplify an RF signal RF_{A} of a band A received from the RFIC 5. Specifically, the power amplifier 2A can operate in the digital ET mode.

The power amplifier 2B is an example of a second power amplifier, which is connected between the RFIC 5 and the filter 3B. The power amplifier 2B is also connected to the pre-regulator circuit 11 and can receive a power supply voltage V_{APT1} based on the APT mode. The power amplifier 2B can use the power supply voltage V_{APT1} received from the pre-regulator circuit 11 to amplify an RF signal RF_{B} of a band B received from the RFIC 5. Specifically, the power amplifier 2B can operate in the APT mode.

The filter 3A is connected between the power amplifier 2A and the antenna 6A. The filter 3A is a band pass filter having a passband including a transmission band of the band A. The filter 3A does not have to be included in the communication device 7A.

The filter 3B is connected between the power amplifier 2B and the antenna 6B. The filter 3B is a band pass filter having a passband including a transmission band of the band B. The filter 3B does not have to be included in the communication device 7A.

Each of the bands A and B is a frequency band for a communication system built using a radio access technology (RAT), and is predefined by a standardizing body or the like (for example, 3GPP (registered trademark) (3rd Generation Partnership Project), IEEE (Institute of Electrical and Electronics Engineers) and the like). Examples of the communication system include a 5GNR (5th Generation New Radio) system, a 4GLTE (4th Generation Long Term Evolution) system, a 3G (3rd Generation) system, a 2G (2nd Generation) system, a WLAN (Wireless Local Area Network) system, and the like.

The band A is an example of a first band, which is included in an ultra-high band group (3300 to 5000 MHz) in this embodiment. Note that the band A is not limited to the frequency band included in the ultra-high band group.

The band B is an example of a second band, which is included in a mid-high band group (1427 to 2690 MHz) or a low band group (698 to 960 MHz) in this embodiment. Note that the band B is not limited to the frequency band included in the mid-high band group or low band group.

Note that the transmission band refers to a frequency band used for transmission in the communication device. For example, in a frequency division duplex (FDD) band, a frequency band different from a reception band is used as the transmission band. In a time division duplex (TDD) band, on the other hand, the same frequency band as the reception band is used as the transmission band. When the communication device functions as a UE of a cellular network, in particular, an uplink operation band is used as the transmission band in the FDD band. When the communication device functions as a BS of the cellular network, on the other hand, a downlink operation band is used as the transmission band in the FDD band.

The RFIC 5 is an example of a signal processing circuit that processes RF signals. Specifically, the RFIC 5 processes an inputted transmission signal by up-conversion or the like, and supplies the radio frequency transmission signal thus generated through signal processing to the power amplifiers 2A and 2B. The RFIC 5 may also include a control unit that controls the tracker circuit 1A. Note that part or all of the function of the RFIC 5 as the control unit may be implemented outside the RFIC 5.

The antenna 6A outputs a transmission signal of the band A inputted from the power amplifier 2A through the filter 3A. The antenna 6A does not have to be included in the communication device 7A.

The antenna 6B outputs a transmission signal of the band B inputted from the power amplifier 2B through the filter 3B. The antenna 6B does not have to be included in the communication device 7A.

The circuit configuration of the communication device 7A illustrated in Fig. 2 is merely an example, and the present invention is not limited to this example. For example, the communication device 7A may include a baseband signal processing circuit that processes signals using an intermediate frequency band that is lower than the RF signals RF_{A} and RF_{B}. The communication device 7A may also include a receive path. The communication device 7A may further include one or more power amplifiers connected to the tracker circuit 1A, in addition to the power amplifier 2A.

### [1.2 Circuit Configuration of Tracker Circuit 1A and Pre-regulator Circuit 11]

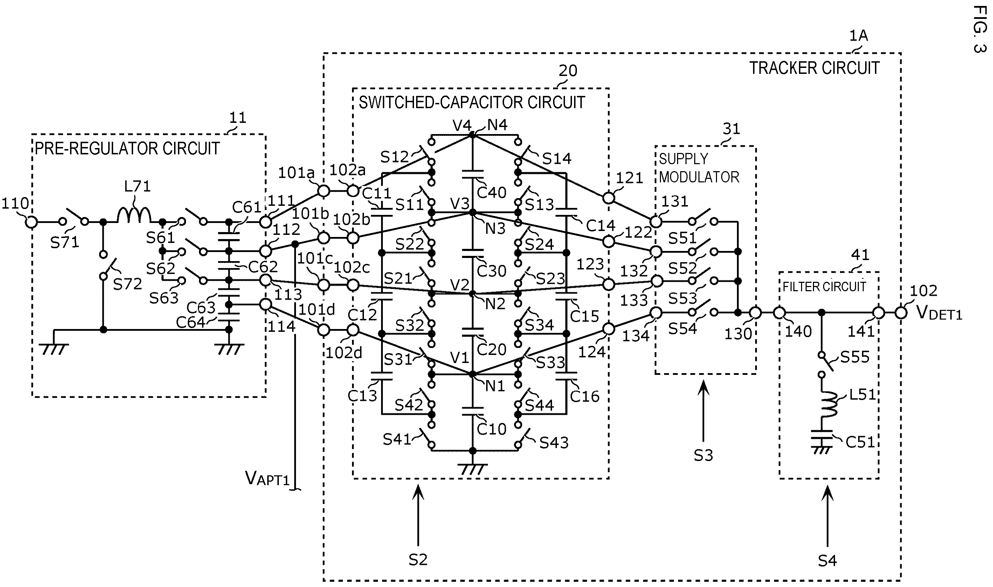

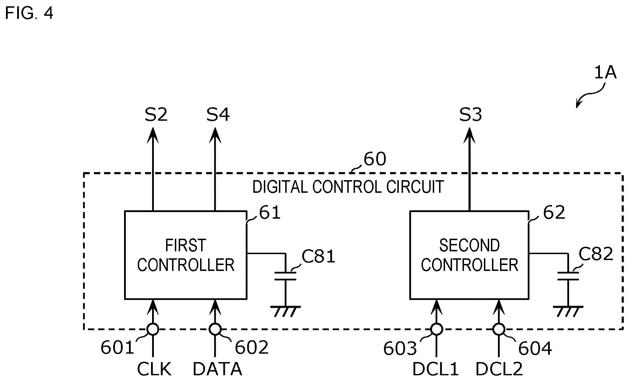

Next, circuit configurations of the tracker circuit 1A and the pre-regulator circuit 11 will be described with reference to Figs. 3 and 4. Fig. 3 is a circuit configuration diagram of the switched-capacitor circuit 20, the supply modulator 31, and the filter circuit 41 included in the tracker circuit 1A according to this embodiment, and the pre-regulator circuit 11. Fig. 4 is a circuit configuration diagram of the digital control circuit 60 included in the tracker circuit 1A according to this embodiment.

Note that Figs. 3 and 4 illustrate exemplary circuit configurations, and the pre-regulator circuit 11, the switched-capacitor circuit 20, the supply modulator 31, the filter circuit 41, and the digital control circuit 60 can be implemented using any of a wide variety of circuit implementations and circuit techniques. Therefore, the description of each circuit provided below should not be interpreted as being limited thereto.

### [1.2.1 Circuit Configuration of Switched-capacitor Circuit 20]

First, a circuit configuration of the switched-capacitor circuit 20 will be described. As illustrated in Fig. 3, the switched-capacitor circuit 20 includes capacitors C11 to C16, capacitors C10, C20, C30, and C40, switches S11 to S14, S21 to S24, S31 to S34, and S41 to S44, input terminals 120a to 120d, and output terminals 121 to 124.

The input terminals 120a to 120d are each an example of a first input terminal. The input terminals 120a to 120d are connected to the external connection terminals 101a to 101d of the tracker circuit 1A, respectively, outside the switched-capacitor circuit 20, and connected to nodes N4 to N1, respectively, inside the switched-capacitor circuit 20. Note that some or all of the input terminals 120a to 120d may be hereinafter referred to as input terminals 120.

The output terminals 121 to 124 are an example of a plurality of first output terminals. The output terminals 121 to 124 are connected to input terminals 131 to 134 of the supply modulator 31, respectively, outside the switched-capacitor circuit 20, and connected to the nodes N4 to N1, respectively, inside the switched-capacitor circuit 20.

Energy and charges are inputted from the pre-regulator circuit 11 to the switched-capacitor circuit 20 through the input terminals 120a to 120d, and are drawn from the switched-capacitor circuit 20 to the supply modulator 31 through the output terminals 121 to 124.

The capacitors C11 to C16 each function as a flying capacitor (sometimes referred to as a transfer capacitor). Specifically, the capacitors C11 to C16 are each used to raise or lower the regulating voltage supplied from the pre-regulator circuit 11. More specifically, the capacitors C11 to C16 transfer charges between the capacitors C11 to C16 and the nodes N1 to N4, so that voltages V1 to V4 (voltages relative to ground potential) that satisfy V1:V2:V3:V4 = 1:2:3:4 are maintained at the four nodes N1 to N4. These voltages V1 to V4 correspond to a plurality of discrete voltages having a plurality of discrete voltage levels.

The capacitor C11 has two electrodes. One of the two electrodes of the capacitor C11 is connected to one end of the switch S11 and one end of the switch S12. The other of the two electrodes of the capacitor C11 is connected to one end of the switch S21 and one end of the switch S22.

The capacitor C12 has two electrodes. One of the two electrodes of the capacitor C12 is connected to one end of the switch S21 and one end of the switch S22. The other of the two electrodes of the capacitor C12 is connected to one end of the switch S31 and one end of the switch S32.

The capacitor C13 has two electrodes. One of the two electrodes of the capacitor C13 is connected to one end of the switch S31 and one end of the switch S32. The other of the two electrodes of the capacitor C13 is connected to one end of the switch S41 and one end of the switch S42.

The capacitor C14 has two electrodes. One of the two electrodes of the capacitor C14 is connected to one end of the switch S13 and one end of the switch S14. The other of the two electrodes of the capacitor C14 is connected to one end of the switch S23 and one end of the switch S24.

The capacitor C15 has two electrodes. One of the two electrodes of the capacitor C15 is connected to one end of the switch S23 and one end of the switch S24. The other of the two electrodes of the capacitor C15 is connected to one end of the switch S33 and one end of the switch S34.

The capacitor C16 has two electrodes. One of the two electrodes of the capacitor C16 is connected to one end of the switch S33 and one end of the switch S34. The other of the two electrodes of the capacitor C16 is connected to one end of the switch S43 and one end of the switch S44.

A set of the capacitors C11 and C14, a set of the capacitors C12 and C15, and a set of the capacitors C13 and C16 can each be charged and discharged complementarily by repeating a first phase and a second phase.

Specifically, in the first phase, the switches S12, S13, S22, S23, S32, S33, S42, and S43 are turned on. As a result, for example, one of the two electrodes of the capacitor C12 is connected to the node N3, the other of the two electrodes of the capacitor C12 and one of the two electrodes of the capacitor C15 are connected to the node N2, and the other of the two electrodes of the capacitor C15 is connected to the node N1.

In the second phase, on the other hand, the switches S11, S14, S21, S24, S31, S34, S41, and S44 are turned on. As a result, for example, one of the two electrodes of the capacitor C15 is connected to the node N3, the other of the two electrodes of the capacitor C15 and one of the two electrodes of the capacitor C12 are connected to the node N2, and the other of the two electrodes of the capacitor C12 is connected to the node N1.

By repeating such first and second phases, when one of the capacitors C12 and C15 is charged from the node N2, for example, the other of the capacitors C12 and C15 can be discharged to the capacitor C30. In other words, the capacitors C12 and C15 can be complementarily charged and discharged.

By repeating the first phase and the second phase, the set of the capacitors C11 and C14 and the set of the capacitors C13 and C16 can also be complementarily charged and discharged, as in the case of the set of the capacitors C12 and C15.

The capacitors C10, C20, C30, and C40 each function as a smoothing capacitor. Specifically, the capacitors C10, C20, C30, and C40 are each used to hold and smooth the voltages V1 to V4 at the nodes N1 to N4.

The capacitor C10 is connected between the node N1 and the ground. Specifically, one of the two electrodes of the capacitor C10 is connected to the node N1. The other of the two electrodes of the capacitor C10 is connected to the ground.

The capacitor C20 is connected between the nodes N2 and N1. Specifically, one of the two electrodes of the capacitor C20 is connected to the node N2. The other of the two electrodes of the capacitor C20 is connected to the node N1.

The capacitor C30 is connected between the nodes N3 and N2. Specifically, one of the two electrodes of the capacitor C30 is connected to the node N3. The other of the two electrodes of the capacitor C30 is connected to the node N2.

The capacitor C40 is connected between the nodes N4 and N3. Specifically, one of the two electrodes of the capacitor C40 is connected to the node N4. The other of the two electrodes of the capacitor C40 is connected to the node N3.

The switch S11 is connected between one of the two electrodes of the capacitor C11 and the node N3. Specifically, one end of the switch S11 is connected to one of the two electrodes of the capacitor C11. The other end of the switch S11 is connected to the node N3.

The switch S12 is connected between one of the two electrodes of the capacitor C11 and the node N4. Specifically, one end of the switch S12 is connected to one of the two electrodes of the capacitor C11. The other end of the switch S12 is connected to the node N4.

The switch S21 is connected between one of the two electrodes of the capacitor C12 and the node N2. Specifically, one end of the switch S21 is connected to one of the two electrodes of the capacitor C12 and the other of the two electrodes of the capacitor C11. The other end of the switch S21 is connected to the node N2.

The switch S22 is connected between one of the two electrodes of the capacitor C12 and the node N3. Specifically, one end of the switch S22 is connected to one of the two electrodes of the capacitor C12 and the other of the two electrodes of the capacitor C11. The other end of the switch S22 is connected to the node N3.

The switch S31 is connected between the other of the two electrodes of the capacitor C12 and the node N1. Specifically, one end of the switch S31 is connected to the other of the two electrodes of the capacitor C12 and one of the two electrodes of the capacitor C13. The other end of the switch S31 is connected to the node N1.

The switch S32 is connected between the other of the two electrodes of the capacitor C12 and the node N2. Specifically, one end of the switch S32 is connected to the other of the two electrodes of the capacitor C12 and one of the two electrodes of the capacitor C13. The other end of the switch S32 is connected to the node N2. That is, the other end of the switch S32 is connected to the other end of the switch S21.

The switch S41 is connected between the other of the two electrodes of the capacitor C13 and the ground. Specifically, one end of the switch S41 is connected to the other of the two electrodes of the capacitor C13. The other end of the switch S41 is connected to the ground.

The switch S42 is connected between the other of the two electrodes of the capacitor C13 and the node N1. Specifically, one end of the switch S42 is connected to the other of the two electrodes of the capacitor C13. The other end of the switch S42 is connected to the node N1. That is, the other end of the switch S42 is connected to the other end of the switch S31.

The switch S13 is connected between one of the two electrodes of the capacitor C14 and the node N3. Specifically, one end of the switch S13 is connected to one of the two electrodes of the capacitor C14. The other end of the switch S13 is connected to the node N3. That is, the other end of the switch S13 is connected to the other end of the switch S11 and the other end of the switch S22.

The switch S14 is connected between one of the two electrodes of the capacitor C14 and the node N4. Specifically, one end of the switch S14 is connected to one of the two electrodes of the capacitor C14. The other end of the switch S14 is connected to the node N4. That is, the other end of the switch S14 is connected to the other end of the switch S12.

The switch S23 is connected between one of the two electrodes of the capacitor C15 and the node N2. Specifically, one end of the switch S23 is connected to one of the two electrodes of the capacitor C15 and the other of the two electrodes of the capacitor C14. The other end of the switch S23 is connected to the node N2. That is, the other end of the switch S23 is connected to the other end of the switch S21 and the other end of the switch S32.

The switch S24 is connected between one of the two electrodes of the capacitor C15 and the node N3. Specifically, one end of the switch S24 is connected to one of the two electrodes of the capacitor C15 and the other of the two electrodes of the capacitor C14. The other end of the switch S24 is connected to the node N3. That is, the other end of the switch S24 is connected to the other end of the switch S11, the other end of the switch S22, and the other end of the switch S13.

The switch S33 is connected between the other of the two electrodes of the capacitor C15 and the node N1. Specifically, one end of the switch S33 is connected to the other of the two electrodes of the capacitor C15 and one of the two electrodes of the capacitor C16. The other end of the switch S33 is connected to the node N1. That is, the other end of the switch S33 is connected to the other end of the switch S31 and the other end of the switch S42.

The switch S34 is connected between the other of the two electrodes of the capacitor C15 and the node N2. Specifically, one end of the switch S34 is connected to the other of the two electrodes of the capacitor C15 and one of the two electrodes of the capacitor C16. The other end of the switch S34 is connected to the node N2. That is, the other end of the switch S34 is connected to the other end of the switch S21, the other end of the switch S32, and the other end of the switch S23.

The switch S43 is connected between the other of the two electrodes of the capacitor C16 and the ground. Specifically, one end of the switch S43 is connected to the other of the two electrodes of the capacitor C16. The other end of the switch S43 is connected to the ground.

The switch S44 is connected between the other of the two electrodes of the capacitor C16 and the node N1.

Specifically, one end of the switch S44 is connected to the other of the two electrodes of the capacitor C16. The other end of the switch S44 is connected to the node N1. That is, the other end of the switch S44 is connected to the other end of the switch S31, the other end of the switch S42, and the other end of the switch S33.

A first set of switches including the switches S12, S13, S22, S23, S32, S33, S42, and S43 and a second set of switches including the switches S11, S14, S21, S24, S31, S34, S41, and S44 are complementarily switched on and off based on a control signal S2. Specifically, in the first phase, the first set of switches are turned on and the second set of switches are turned off. In the second phase, on the other hand, the first set of switches are turned off and the second set of switches are turned on.

For example, in one of the first and second phases, the capacitors C10 to C40 are charged from the capacitors C11 to C13. In the other of the first and second phases, the capacitors C10 to C40 are charged from the capacitors C14 to C16. Specifically, the capacitors C10 to C40 are constantly charged from the capacitors C11 to C13 or the capacitors C14 to C16. Therefore, even when a current rapidly flows from the nodes N1 to N4 to the supply modulator 31, charges are rapidly supplied to the nodes N1 to N4, thus making it possible to suppress fluctuation in potential at the nodes N1 to N4.

Through such an operation, the switched-capacitor circuit 20 can maintain substantially the same voltage at both ends of the capacitors C10, C20, C30, and C40. Specifically, at the four nodes labeled V1 to V4, the voltages V1 to V4 (voltages relative to the ground potential) that satisfy V1:V2:V3:V4 = 1:2:3:4 are maintained. The voltage levels of the voltages V1 to V4 correspond to a plurality of discrete voltage levels of voltages that can be supplied to the supply modulator 31 by the switched-capacitor circuit 20.

The voltage ratio (V1:V2:V3:V4) is not limited to (1:2:3:4). For example, the voltage ratio (V1:V2:V3:V4) may be (1:2:4:8).

The configuration of the switched-capacitor circuit 20 illustrated in Fig. 3 is merely an example, and the present invention is not limited to this example. While, in Fig. 3, the switched-capacitor circuit 20 is configured to be able to supply voltages of four discrete voltage levels, the present invention is not limited thereto. The switched-capacitor circuit 20 may be configured to be able to supply voltages of any number of discrete voltage levels, such as greater than or equal to two. In the case of supplying voltages of two discrete voltage levels, for example, the switched-capacitor circuit 20 may include at least the capacitors C12 and C15 and the switches S21 to S24 and S31 to S34.

### [1.2.2 Circuit Configuration of Supply Modulator 31]

Next, a circuit configuration of the supply modulator 31 will be described. The supply modulator 31 is connected to the digital control circuit 60. As illustrated in Fig. 3, the supply modulator 31 includes the input terminals 131 to 134, switches S51 to S54, and an output terminal 130.

The output terminal 130 is an example of a second output terminal, which is connected to the external connection terminal 102 through the filter circuit 41. The output terminal 130 is a terminal for supplying a power supply voltage selected from among the voltages V1 to V4 to the power amplifier 2A through the external connection terminal 102.

The input terminals 131 to 134 are connected to the nodes N4 to N1 of the switched-capacitor circuit 20, respectively. The input terminals 131 to 134 are an example of a plurality of second input terminals. The input terminals 131 to 134 are terminals for receiving the voltages V4 to V1 from the switched-capacitor circuit 20.

The switch S51 is connected between the input terminal 131 and the output terminal 130. Specifically, the switch S51 has a terminal connected to the input terminal 131 and a terminal connected to the output terminal 130. In this connection configuration, the switch S51 can be switched on and off (closed and open) based on a control signal S3, thereby switching between connection and non-connection between the input terminal 131 and the output terminal 130.

The switch S52 is connected between the input terminal 132 and the output terminal 130. Specifically, the switch S52 has a terminal connected to the input terminal 132 and a terminal connected to the output terminal 130. In this connection configuration, the switch S52 can be switched on and off based on the control signal S3, thereby switching between connection and non-connection between the input terminal 132 and the output terminal 130.

The switch S53 is connected between the input terminal 133 and the output terminal 130. Specifically, the switch S53 has a terminal connected to the input terminal 133 and a terminal connected to the output terminal 130. In this connection configuration, the switch S53 can be switched on and off based on the control signal S3, thereby switching between connection and non-connection between the input terminal 133 and the output terminal 130.

The switch S54 is connected between the input terminal 134 and the output terminal 130. Specifically, the switch S54 has a terminal connected to the input terminal 134 and a terminal connected to the output terminal 130. In this connection configuration, the switch S54 can be switched on and off based on the control signal S3, thereby switching between connection and non-connection between the input terminal 134 and the output terminal 130.

These switches S51 to S54 are controlled to be exclusively on. That is, only one of the switches S51 to S54 is turned on, and the rest of the switches S51 to S54 are turned off. This allows the supply modulator 31 to output one voltage selected from among the voltages V1 to V4.

Note that the configuration of the supply modulator 31 illustrated in Fig. 3 is merely an example, and the present invention is not limited to this example. The switches S51 to S54, in particular, may have any configuration as long as at least one of the four input terminals 131 to 134 can be selectively connected to the output terminal 130. For example, the supply modulator 31 may further include a switch connected between the switches S51 to S53 and the switch S54 and the output terminal 130. For example, the supply modulator 31 may also further include a switch connected between the switches S51 and S52, and the switches S53 and S54 and the output terminal 130.

When voltages of two discrete voltage levels are supplied from the switched-capacitor circuit 20, the supply modulator 31 may include at least two of the switches S51 to

S54.

### [1.2.3 Circuit Configuration of Pre-regulator Circuit 11]

First, a configuration of the pre-regulator circuit 11 will be described. As illustrated in Fig. 3, the pre-regulator circuit 11 includes an input terminal 110, output terminals 111 to 114, inductor connection terminals 115 and 116, switches S61 to S63, S71, and S72, a power inductor L71 (an example of a first power inductor), and capacitors C61 to C64.

The input terminal 110 is an input terminal for a DC voltage. In other words, the input terminal 110 is a terminal connected to the DC power source 50 to receive an input voltage from the DC power source 50.

The output terminal 111 is an output terminal for the voltage V4. In other words, the output terminal 111 is a terminal for supplying the voltage V4 to the switched-capacitor circuit 20. The output terminal 111 is connected to the external connection terminal 101a of the tracker circuit 1A.

The output terminal 112 is an output terminal for the voltage V3. In other words, the output terminal 112 is a terminal for supplying the voltage V3 to the switched-capacitor circuit 20. The output terminal 112 is connected to the external connection terminal 101b of the tracker circuit 1A. The output terminal 112 is also connected to the power amplifier 2B without passing through the tracker circuit 1A. That is, the pre-regulator circuit 11 is connected to the switched-capacitor circuit 20 and also connected to the power amplifier 2B without passing through the switched-capacitor circuit 20 and the supply modulator 31.

The output terminal 113 is an output terminal for the voltage V2. That is, the output terminal 113 is a terminal for supplying the voltage V2 to the switched-capacitor circuit 20. The output terminal 113 is connected to the external connection terminal 101c of the tracker circuit 1A.

The output terminal 114 is an output terminal for the voltage V1. That is, the output terminal 114 is a terminal for supplying the voltage V1 to the switched-capacitor circuit 20. The output terminal 114 is connected to the external connection terminal 101d of the tracker circuit 1A.

The inductor connection terminal 115 is connected to one end of the power inductor L71. The inductor connection terminal 116 is connected to the other end of the power inductor L71.

The switch S71 is connected between the input terminal 110 and one end of the power inductor L71. Specifically, the switch S71 has a terminal connected to the input terminal 110 and a terminal connected to one end of the power inductor L71 through the inductor connection terminal 115. In this connection configuration, the switch S71 can be switched on and off to switch between connection and non-connection between the input terminal 110 and one end of the power inductor L71.

The switch S72 is connected between one end of the power inductor L71 and the ground. Specifically, the switch S72 has a terminal connected to one end of the power inductor L71 through the inductor connection terminal 115 and a terminal connected to the ground. In this connection configuration, the switch S72 can be switched on and off to switch between connection and non-connection between one end of the power inductor L71 and the ground.

The switch S61 is connected between the other end of the power inductor L71 and the output terminal 111. Specifically, the switch S61 has a terminal connected to the other end of the power inductor L71 through the inductor connection terminal 116 and a terminal connected to the output terminal 111. In this connection configuration, the switch S61 can be switched on and off to switch between connection and non-connection between the other end of the power inductor L71 and the output terminal 111.

The switch S62 is connected between the other end of the power inductor L71 and the output terminal 112. Specifically, the switch S62 has a terminal connected to the other end of the power inductor L71 through the inductor connection terminal 116 and a terminal connected to the output terminal 112. In this connection configuration, the switch S62 can be switched on and off to switch between connection and non-connection between the other end of the power inductor L71 and the output terminal 112.

The switch S63 is connected between the other end of the power inductor L71 and the output terminal 113. Specifically, the switch S63 has a terminal connected to the other end of the power inductor L71 through the inductor connection terminal 116 and a terminal connected to the output terminal 113. In this connection configuration, the switch S63 can be switched on and off to switch between connection and non-connection between the other end of the power inductor L71 and the output terminal 113.

One of the two electrodes of the capacitor C61 is connected to the switch S61 and the output terminal 111. The other of the two electrodes of the capacitor C61 is connected to the switch S62, the output terminal 112, and one of the two electrodes of the capacitor C62.

One of the two electrodes of the capacitor C62 is connected to the switch S62, the output terminal 112, and the other of the two electrodes of the capacitor C61. The other of the two electrodes of the capacitor C62 is connected to a path connecting the switch S63, the output terminal 113, and one of the two electrodes of the capacitor C63.

One of the two electrodes of the capacitor C63 is connected to the switch S63, the output terminal 113, and the other of the two electrodes of the capacitor C62. The other of the two electrodes of the capacitor C63 is connected to the output terminal 114 and one of the two electrodes of the capacitor C64.

One of the two electrodes of the capacitor C64 is connected to the output terminal 114 and the other of the two electrodes of the capacitor C63. The other of the two electrodes of the capacitor C64 is connected to the ground.

The switches S61 to S63 are controlled to be exclusively on. In other words, only one of the switches S61 to S63 is turned on, and the rest of the switches S61 to S63 are turned off. By turning on only one of the switches S61 to S63, the pre-regulator circuit 11 can change the voltage supplied to the switched-capacitor circuit 20 between the voltage levels of the voltages V2 to V4.

The pre-regulator circuit 11 thus configured can supply charges to the switched-capacitor circuit 20 through at least one of the output terminals 111 to 113.

When the input voltage is converted into one regulating voltage, the pre-regulator circuit 11 only needs to include at least the switches S71 and S72, the power inductor L71, the input terminal 110, and any one of the output terminals 111 to 114. In this case, the external connection terminals 101a to 101d of the tracker circuit 1A may be replaced with one external connection terminal.

### [1.2.4 Circuit Configuration of Filter Circuit 41]

Next, a circuit configuration of the filter circuit 41 will be described. The filter circuit 41 includes an input terminal 140, an output terminal 141, an inductor L51, a capacitor C51, and a switch S55.

The input terminal 140 is connected to the output terminal 130 of the supply modulator 31 outside the filter circuit 41, and connected to the output terminal 141 inside the filter circuit 41.

The output terminal 141 is connected to the external connection terminal 102 of the tracker circuit 1A outside the filter circuit 41, and connected to the input terminal 140 inside the filter circuit 41.

The inductor L51 and the capacitor C51 form an RC series circuit, and are connected between a path connecting the input terminal 140 and the output terminal 141 and the ground through the switch S55. In this embodiment, the inductor L51 is connected between the switch S55 and the capacitor C51. Specifically, one end of the switch S55 is connected to the input terminal 140 and the output terminal 141, and the other end of the switch S55 is connected to the inductor L51. One end of the inductor L51 is connected to the switch S55, and the other end of the inductor L51 is connected to the capacitor C51. One end of the capacitor C51 is connected to the inductor L51, and the other end of the capacitor C51 is connected to the ground.

The switch S55 thus connected is switched on and off based on the control signal S4. For example, on and off of the switch S55 is controlled as follows. (1) When a channel band width (that is, modulation band width) of the RF signal RF_{A} is greater than or equal to a threshold width, the switch S55 is opened (turned off). This causes the inductor L51 and the capacitor C51 to be disconnected from a voltage supply path. In this event, a power supply voltage V_{DET1} is supplied to the power amplifier 2A through the external connection terminal 102, but the filter circuit 41 does not function as a band elimination filter (sometimes referred to as a notch filter) in the voltage supply path. (2) When the channel band width of the RF signal RF_{A} is less than the threshold width, the switch S55 is closed (turned on). This causes the inductor L51 and the capacitor C51 to be connected in shunt with the voltage supply path. In this event, the power supply voltage V_{DET1} is supplied to the power amplifier 2A through the external connection terminal 102, and the filter circuit 41 functions as the band elimination filter in the voltage supply path.

As the threshold width used in controlling the switch S55, a value (for example, 100 MHz or the like) that is experimentally and/or empirically predetermined can be used.

The stopband of the filter circuit 41 is a band that depends on the threshold width. For example, when 100 MHz is used as the threshold width and 0.5 is used as a predetermined coefficient, the stopband of the filter circuit 41 includes a frequency (50 MHz) obtained by multiplying the threshold width value (100 MHz) by the predetermined coefficient (0.5). This allows the filter circuit 41 to reduce noise components near 50 MHz in the voltage supply path. As a result, the IMD between the RF signal RF_{A} and the noise (50 MHz component) in the power amplifier 2A can be suppressed, making it possible to reduce adjacent channel leakage power (ACP) in the power amplifier 2A.

The stopband is defined as a band having an insertion loss of more than or equal to 20 dB. Therefore, the stopband of the filter circuit 41 can be identified by measuring the power loss between the input terminal 140 and the output terminal 141 of the filter circuit 41 and detecting the band where the measured loss is more than or equal to 20 dB.

Note that the configuration of the filter circuit 41 illustrated in Fig. 3 is merely an example, and the present invention is not limited to this example. For example, the filter circuit 41 does not have to include the switch S55. For example, the switch S55 may also be connected between the capacitor C51 and the ground.

The control of the switch S55 described above is merely an example, and the present invention is not limited to the above description. For example, when the power amplifier 2A selectively amplifies transmission signals of a plurality of bands, the on and off of the switch S55 may be controlled according to the band of the transmission signal to be amplified.

### [1.2.5 Circuit Configuration of Digital Control Circuit 60]

Next, a circuit configuration of the digital control circuit 60 included in the tracker circuit 1A will be described. As illustrated in Fig. 4, the digital control circuit 60 includes a first controller 61, a second controller 62, capacitors C81 and C82, and control terminals 601 to 604.

The first controller 61 can process source-synchronous digital control signals received from the RFIC 5 through the control terminals 601 and 602 to generate the control signals S2 and S4. The control signal S2 is a signal for controlling on and off of the switches S11 to S14, S21 to S24, S31 to S34, and S41 to S44 included in the switched-capacitor circuit 20. The control signal S4 is a signal for controlling on and off of the switch S55 included in the filter circuit 41.

The digital control signal processed by the first controller 61 is not limited to the source-synchronous digital control signal. For example, the first controller 61 may process a clock-embedded digital control signal. The first controller 61 may also generate a control signal for controlling the supply modulator 31.

In this embodiment, a set of clock signals and data signals are used as the digital control signals for the pre-regulator circuit 11, the switched-capacitor circuit 20, and the filter circuit 41. However, the present invention is not limited thereto. For example, sets of clock signals and data signals may be used individually as the digital control signals for the pre-regulator circuit 11, the switched-capacitor circuit 20, and the filter circuit 41.

The second controller 62 processes a digital control logic/line (DCL) signals (DCL1 and DCL2) received from the RFIC 5 through the control terminals 603 and 604 to generate the control signal S3. The DCL signals (DCL1 and DCL2) are generated by the RFIC 5 based on an envelope signal of an RF signal or the like. The control signal S3 is a signal for controlling on and off of the switches S51 to S54 included in the supply modulator 31.

The DCL signals (DCL1 and DCL2) are each a 1-bit signal. The voltages V1 to V4 are each represented by a combination of two 1-bit signals. For example, V1, V2, V3, and V4 are represented by "00", "01", "10", and **"11",** respectively. The gray code may be used to represent the voltage levels.

The capacitor C81 is connected between the first controller 61 and the ground. For example, the capacitor C81 is connected between a power supply line that supplies power to the first controller 61 and the ground, and functions as a bypass capacitor. The capacitor C82 is connected between the second controller 62 and the ground.

In this embodiment, two digitally controlled level (DCL) signals are used to control the supply modulator 31. However, the number of DCL signals is not limited thereto. For example, one or any number of DCL signals, such as greater than or equal to three, may be used depending on the number of voltage levels that can be selected by each supply modulator 31. The digital control signal used to control the supply modulator 31 is not limited to the DCL signal.

### [1.3 Tracking Method]

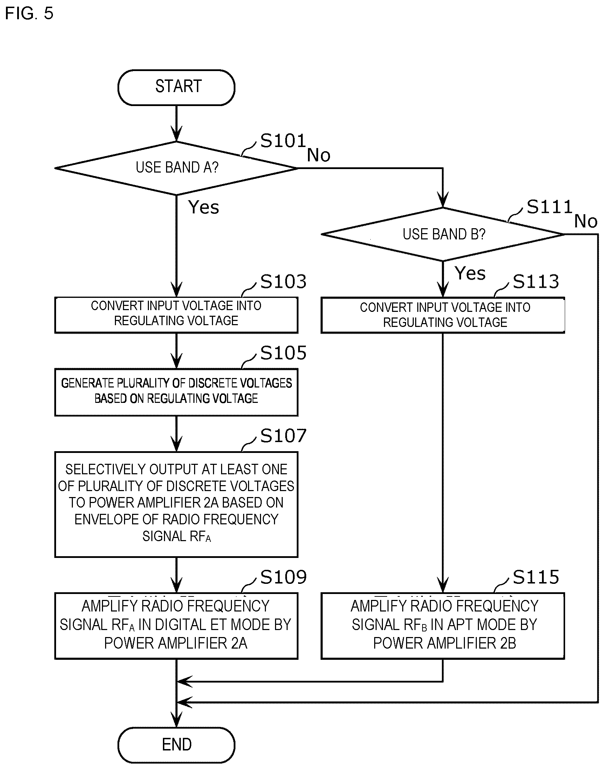

Next, a tracking method will be described with reference to Fig. 5, which is a method of supplying a plurality of discrete voltages in the communication device 7A configured as described above. Fig. 5 is a flowchart illustrating the tracking method according to this embodiment.

Note that Fig. 5 is an exemplary flowchart, and the tracking method is not limited to the steps and the order of steps in Fig. 5. Therefore, the description of the tracking method provided below should not be interpreted as being limited thereto.

For example, the RFIC 5 determines whether to use the band A for radio frequency communication (S101). When it is determined that the band A is to be used (Yes in S101), the pre-regulator circuit 11 converts the input voltage into a regulating voltage (S103). Here, the input voltage is converted into a fixed voltage. The switched-capacitor circuit 20 generates a plurality of discrete voltages based on the regulating voltage (S105). The supply modulator 31 selectively outputs at least one of the plurality of discrete voltages to the power amplifier 2A based on the envelope of the RF signal RF_{A} (S107). This allows a power supply voltage V_{DET1} to be supplied which changes in a plurality of discrete levels over time according to the envelope of the RF signal RF_{A}, to the power amplifier **2A.** The power amplifier 2A uses the power supply voltage V_{DET1} to amplify the RF signal RF_{A} (S109). The power amplifier 2A can thus amplify the RF signal RF_{A} in the digital ET mode.

When it is determined, on the other hand, that the band A is not to be used (No in S101), it is determined whether to use the band B for radio frequency communication (S111). Here, when it is determined that the band B is not to be used (No in S111), the processing ends as is. On the other hand, when it is determined that the band B is to be used (Yes in S111), the pre-regulator circuit 11 converts the input voltage into a regulating voltage and outputs this regulating voltage to the power amplifier 2B (S113). Here, the input voltage is converted into a regulating voltage that changes in a plurality of discrete levels on a frame-by-frame basis, for example, according to the average power. The power amplifier 2B uses a power supply voltage V_{APT1} to amplify the RF signal RF_{B} (S115). The power amplifier 2B can thus amplify the RF signal RF_{b} in the APT mode.

### [1.4 Mounting Example of Tracker Circuit 1A]

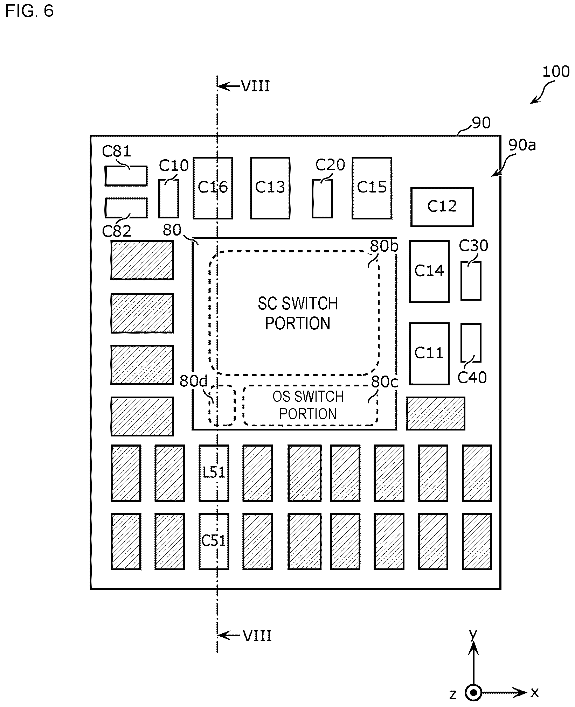

Next, with reference to Figs. 6 to 8, a tracker module 100 will be described as a mounting example of the tracker circuit 1A configured as described above.

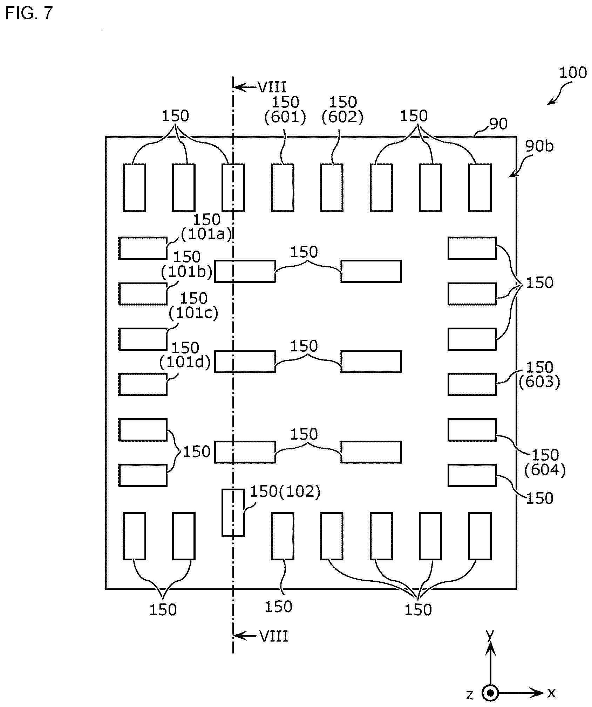

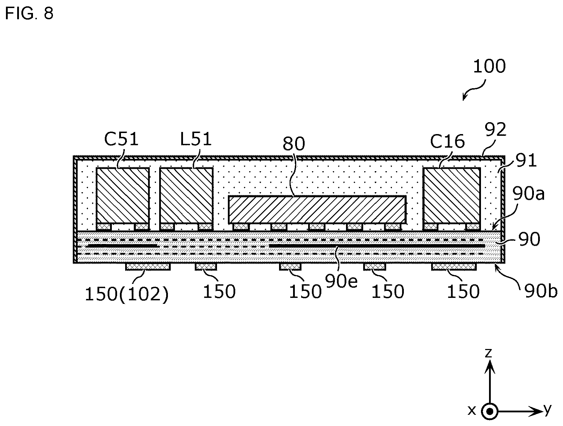

Fig. 6 is a plan view of the tracker module 100 according to this embodiment. Fig. 7 is a plan view of the tracker module 100 according to this embodiment, seen through the main surface 90b side of a module laminate 90 from the positive side of the z-axis. Fig. 8 is a cross-sectional view of the tracker module 100 according to this embodiment. The cross-section of the tracker module 100 in Fig. 8 is taken along line VIII-VIII in Figs. 6 and 7.

In Figs. 6 to 8, some of the wiring connecting a plurality of circuit components arranged on the module laminate 90 is omitted. In Figs. 6 and 7, a resin member 91 covering the plurality of circuit components and a shield electrode layer 92 covering the surface of the resin member 91 are omitted. In Fig. 6, hatched blocks represent optional circuit components that are not essential to the present invention.

The tracker module 100 includes the module laminate 90, the resin member 91, the shield electrode layer 92, and a plurality of electrodes 150, in addition to the plurality of circuit components including the switched-capacitor circuit 20, the supply modulator 31, the filter circuit 41, and the active and passive elements included in the digital control circuit 60 illustrated in Figs. 3 and 4.

The module laminate 90 has main surfaces 90a and 90b facing each other. A ground plane 90e and the like are formed within the module laminate 90 and on the main surface 90a. The module laminate 90 has a rectangular shape in plan view of Figs. 6 and 7, but the present invention is not limited to this shape.

The module laminate 90 may be, but not limited to, for example, a low temperature co-fired ceramics (LTCC) board or high temperature co-fired ceramics (HTCC) board having a laminate structure of a plurality of dielectric layers, a component-embedded board, a board having a redistribution layer (RDL), a printed circuit board or the like.

On the main surface 90a, an integrated circuit 80, capacitors C10 to C16, C20, C30, C40, C51, C81, and C82, an inductor L51, and the resin member 91 are arranged.

The integrated circuit 80 includes an SC switch portion 80b, an OS switch portion 80c, and a filter switch portion 80d. The SC switch portion 80b includes switches S11 to S14, S21 to S24, S31 to S34, and S41 to S44. The OS switch portion 80c includes switches S51 to S54. The filter switch portion 80d includes a switch S55.

While the SC switch portion 80b, the OS switch portion 80c, and the filter switch portion 80d are included in the single integrated circuit 80 in Fig. 6, the present invention is not limited thereto. For example, the SC switch portion 80b may be included in one integrated circuit, and the OS switch portion 80c and the filter switch portion 80d may be included in another integrated circuit. Alternatively, the SC switch portion 80b, the OS switch portion 80c, and the filter switch portion 80d may be included in three separate integrated circuits.

The integrated circuit 80 has a rectangular shape in plan view of the module laminate 90 in Fig. 6, but the present invention is not limited to this shape.

The integrated circuit 80 is configured using a complementary metal oxide semiconductor (CMOS), for example. Specifically, the integrated circuit 80 may be manufactured by a silicon on insulator (SOI) process. The integrated circuit 80 is not limited to the CMOS.

The capacitors C10 to C16, C20, C30, C40, C51, C81, and C82 are each mounted as a chip capacitor. The chip capacitor refers to a surface mount device (SMD) that constitutes a capacitor. Note that the plurality of capacitors to be mounted are not limited to the chip capacitors. For example, some or all of the plurality of capacitors may be included in an integrated passive device (IPD) or may be included in the integrated circuit 80.

The inductor L51 is mounted as a chip inductor. The chip inductor refers to an SMD that constitutes an inductor. Note that the inductor L51 to be mounted is not limited to the chip inductor. For example, the inductor L51 may be included in an IPD.

The plurality of capacitors and inductors thus arranged on the main surface 90a are grouped by circuit and arranged around the integrated circuit 80.

The group including the capacitors C10 to C16, C20, C30, and C40 included in the switched-capacitor circuit 20 is disposed in a region on the main surface 90a sandwiched between a straight line along the top side of the integrated circuit 80 and a straight line along the top side of the module laminate 90, and in a region on the main surface 90a sandwiched between a straight line along the right side of the integrated circuit 80 and a straight line along the right side of the module laminate 90, in plan view of the module laminate 90. This allows the group of circuit components included in the switched-capacitor circuit 20 to be arranged near the SC switch portion 80b in the integrated circuit 80. That is, the SC switch portion 80b is disposed closer to the switched-capacitor circuit 20 than the OS switch portion 80c.

The group including the capacitor C51 and the inductor L51 included in the filter circuit 41 is disposed in a region on the main surface 90a sandwiched between a straight line along the bottom side of the integrated circuit 80 and a straight line along the bottom side of the module laminate 90 in plan view of the module laminate 90. This allows the group of circuit components included in the filter circuit 41 to be disposed near the filter switch portion 80d in the integrated circuit 80. That is, the filter switch portion 80d is disposed closer to the capacitor C51 and the inductor L51 in the filter circuit 41 than the SC switch portion 80b.

The plurality of electrodes 150 are arranged on the main surface 90b. Some of the plurality of electrodes 150 function as the external connection terminals 101a to 101d and 102 illustrated in Fig. 2. The plurality of electrodes 150 are electrically connected to a plurality of electronic components arranged on the main surface 90a through via conductors or the like formed in the module laminate 90. The plurality of electrodes 150 may be, but not limited to, copper electrodes. For example, the plurality of electrodes may be solder electrodes.

The resin member 91 covers the main surface 90a and at least some of the plurality of electronic components on the main surface 90a. The resin member 91 has a function to ensure the reliability of the plurality of electronic components on the main surface 90a, such as mechanical strength and moisture resistance. The resin member 91 does not have to be included in the tracker module 100.

The shield electrode layer 92 is a metal thin film formed by a sputtering method, for example. The shield electrode layer 92 is formed so as to cover the surface (top and side) of the resin member 91. The shield electrode layer 92 is connected to the ground and prevents external noise from entering the electronic components included in the tracker module 100, and also prevents noise generated in the tracker module 100 from interfering with other modules or other devices. The shield electrode layer 92 does not have to be included in the tracker module 100.

Note that the configuration of the tracker module 100 illustrated in Figs. 6 to 8 is merely an example, and the present invention is not limited to this example. For example, some of the capacitors and inductors arranged on the main surface 90a may be formed in the module laminate 90. Moreover, some of the capacitors and inductors arranged on the main surface 90a do not have to be included in the tracker module 100, and do not have to be arranged on the module laminate 90.

### [1.5 Example of Module Layout in Communication Device 7A]

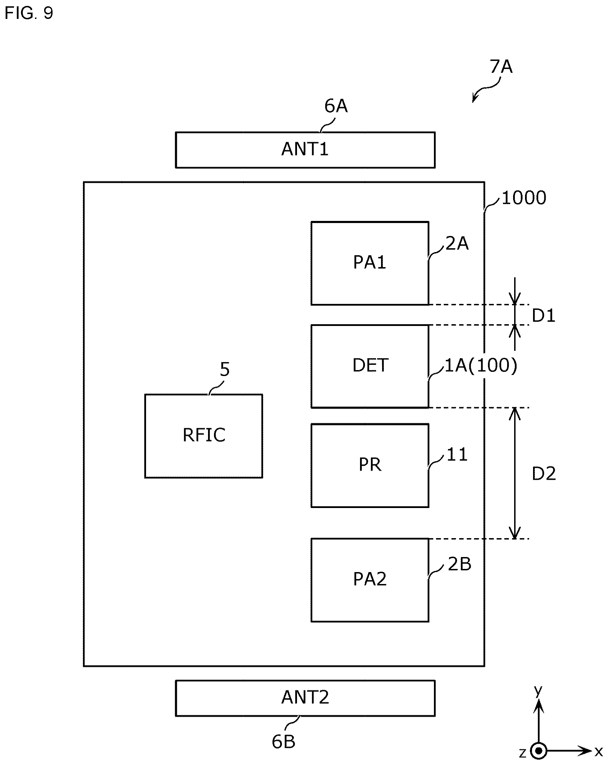

Next, a mounting example of the communication device 7A will be described with reference to Fig. 9. Fig. 9 is a layout diagram of modules in the communication device 7A according to this embodiment. In Fig. 9, each module is denoted by an abbreviation (such as "PA") that indicates its function, so that the layout relationship between the modules can be easily understood, but the actual modules do not need to be denoted by such abbreviations.

On a motherboard 1000, the tracker module 100 (DET) including the tracker circuit 1A, PA modules (PA1 and PA2) including the power amplifiers 2A and 2B, respectively, the RFIC 5, and a PR module (PR) including the pre-regulator circuit 11 are arranged.

The PA module (PA1) including the power amplifier 2A may include a filter 3A, and the PA module (PA2) including the power amplifier 2B may include a filter 3B.

In plan view of the motherboard 1000, the tracker module 100 (DET) is disposed between the PR module (PR) and the PA module (PA1) including the power amplifier 2A. The tracker module 100 (DET) is also disposed near the PA module (PA1) including the power amplifier 2A. That is, in plan view of the motherboard 1000, a distance D1 between the tracker module 100 (DET) and the PA module (PA1) including the power amplifier 2A is shorter than a distance D2 between the tracker module 100 (DET) and the PA module (PA2) including the power amplifier 2B. In other words, the distance between the switched-capacitor circuit 20 and the power amplifier 2A is shorter than the distance between the switched-capacitor circuit 20 and the power amplifier 2B.

The antenna 6A (ANT1) is disposed on the top side of the motherboard 1000 and is disposed near the PA module (PA1) including the power amplifier 2A. The antenna 6B (ANT2) is disposed on the bottom side of the motherboard 1000 and is disposed near the PA module (PA2) including the power amplifier 2B.

### [1.6 Effects and the like]

As described above, the tracker circuit 1A according to this embodiment is the tracker circuit 1A connected to the pre-regulator circuit 11 configured to convert the input voltage to the regulating voltage, including: the switched-capacitor circuit 20 configured to generate a plurality of discrete voltages based on the regulating voltage; and the supply modulator 31 configured to selectively output at least one of the plurality of discrete voltages to the power amplifier 2A. The pre-regulator circuit 11 is configured to output the regulating voltage to the switched-capacitor circuit 20, and to output the regulating voltage to the power amplifier 2B without passing through the switched-capacitor circuit 20.

From another perspective, the tracker circuit 1A according to this embodiment includes: the external connection terminals 101a to 101d connected to the pre-regulator circuit 11 including the power inductor L71; the external connection terminal 102 connected to the power amplifier 2A; the switched-capacitor circuit 20 including the input terminals 120a to 120d connected to the external connection terminals 101a to 101d and the output terminals 121 to 124; and the supply modulator 31 including the input terminals 131 to 134 connected to the output terminals 121 to 124, respectively, and the output terminal 130 connected to the external connection terminal 102. The pre-regulator circuit 11 is further connected to the power amplifier 2B without passing through the switched-capacitor circuit 20 and the supply modulator 31.

With the above configuration, the tracker circuit 1A can supply a plurality of discrete voltages to the power amplifier 2A, and the pre-regulator circuit 11 can supply the regulating voltage directly to the power amplifier 2B. This allows the plurality of discrete voltages to be supplied to the power amplifier 2A, making it possible to discretely change the level of the power supply voltage according to the RF signal, and to improve the power-added efficiency. On the other hand, the regulating voltage is supplied to the power amplifier 2B without passing through the tracker circuit 1A. This makes it possible to reduce the loss in the tracker circuit 1A and to improve the power-added efficiency.

For example, in the tracker circuit 1A according to this embodiment, the power amplifier 2A may be configured to operate in the digital ET mode, and the power amplifier 2B may be configured to operate in the APT mode.

This makes it possible to improve the power-added efficiency by using the digital ET mode in the power amplifier 2A and by using the APT mode in the power amplifier 2B.

For example, in the tracker circuit 1A according to this embodiment, the power amplifier 2A may be configured to amplify a transmission signal of the band A included in the range of 3300 to 5000 MHz, and the power amplifier 2B may be configured to amplify a transmission signal of the band B included in the range of 1427 to 2690 MHz or the range of 698 to 960 MHz.

This makes it possible to use the digital ET mode for the frequency band of the ultra-high band group that allows a higher maximum output power. The power-added efficiency can thus be improved more effectively.

For example, in the tracker circuit 1A according to this embodiment, the distance D1 between the switched-capacitor circuit 20 and the power amplifier 2A may be shorter than the distance D2 between the switched-capacitor circuit 20 and the power amplifier 2B.

This allows the power amplifier 2A to be disposed near the switched-capacitor circuit 20. Therefore, the voltage supply path from the switched-capacitor circuit 20 to the power amplifier 2A can be shortened, making it possible to suppress deterioration of the power supply voltage.

For example, in the tracker circuit 1A according to this embodiment, the pre-regulator circuit 11, the switched-capacitor circuit 20, and the power amplifier 2A may be arranged on the same motherboard 1000. In plan view of the motherboard 1000, the switched-capacitor circuit 20 may be disposed between the pre-regulator circuit 11 and the power amplifier 2A.

This makes it possible to shorten the voltage supply path from the pre-regulator circuit 11 to the power amplifier 2A through the switched-capacitor circuit 20, and to suppress the deterioration of the power supply voltage.

The radio frequency communication system (communication device 7A) according to this embodiment includes the tracker circuit 1A, the pre-regulator circuit 11, the power amplifier 2A, and the power amplifier 2B.

This makes it possible to achieve the same effect as that of the tracker circuit 1A described above in the radio frequency communication system.

The tracking method according to this embodiment includes: converting an input voltage to a regulating voltage using the power inductor L71; generating a plurality of discrete voltages based on the regulating voltage; selectively supplying at least one of the plurality of discrete voltages to the power amplifier 2A; and supplying the regulating voltage to the power amplifier 2B after skipping the generation of the plurality of discrete voltages.

This makes it possible to selectively supply at least one of the plurality of discrete voltages to the power amplifier 2A, and to supply the regulating voltage to the power amplifier 2B after skipping the generation of the plurality of discrete voltages. Therefore, the deterioration of the regulating voltage due to the generation of the plurality of discrete voltages can be suppressed when supplying the regulating voltage to the power amplifier 2B, making it possible to improve the power-added efficiency.

For example, in the tracking method according to this embodiment, the power amplifier 2A may be configured to amplify the RF signal RF_{A} of the band A in the digital ET mode, and the power amplifier 2B may be configured to amplify the RF signal RF_{B} of the band B in the APT mode. When the band A is used for communication, the conversion of the input voltage, the generation of the plurality of discrete voltages, and the selective supply of the plurality of discrete voltages to the power amplifier 2A may be performed. When the band B is used for communication, the conversion of the input voltage and the supply of the regulating voltage to the power amplifier 2B may be performed while skipping the generation of the plurality of discrete voltages.

With the above configuration, in the case of switching between the digital ET mode and the APT mode depending on the band used for communication, deterioration of the power supply voltage in the APT mode can be suppressed, and the power-added efficiency can be improved.

### (Embodiment 2)

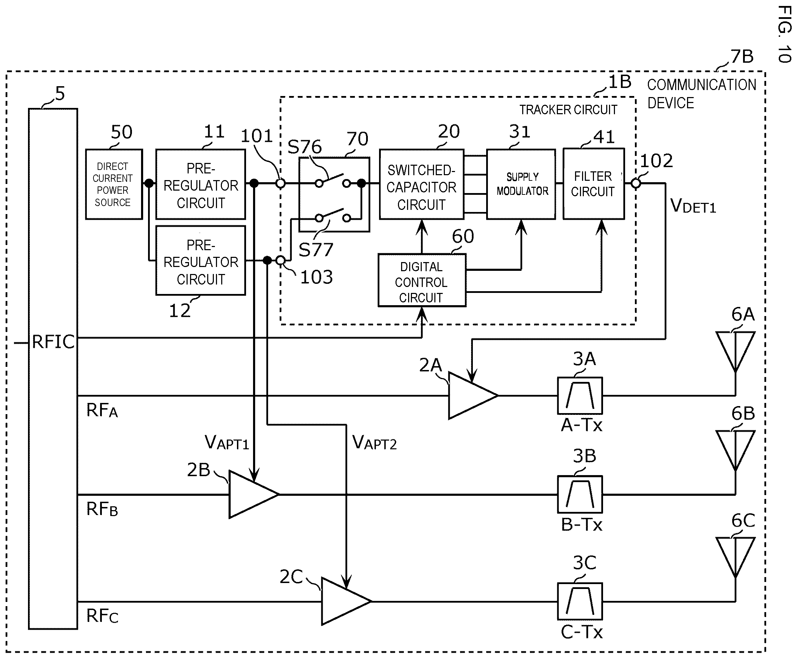

Next, Embodiment 2 will be described. A tracker circuit 1B according to this embodiment is mainly different from the tracker circuit 1A according to Embodiment 1 in that the tracker circuit 1B can selectively connect to a plurality of pre-regulator circuits. The tracker circuit 1B according to this embodiment will be described below with reference to Fig. 10, focusing on differences from the tracker circuit 1A according to Embodiment 1. Fig. 10 is a circuit configuration diagram of a communication device 7B according to this embodiment.

Note that Fig. 10 illustrates an exemplary circuit configuration, and the communication device 7B and the tracker circuit 1B can be implemented using any of a wide variety of circuit implementations and circuit techniques. Therefore, the following description of the communication device 7B and the tracker circuit 1B should not be interpreted as being limited thereto.

### [2.1 Circuit Configuration of Communication Device 7B]

First, the communication device 7B according to this embodiment will be described with reference to Fig. 10. The communication device 7B includes the tracker circuit 1B, power amplifiers 2A to 2C, filters 3A to 3C, an RFIC 5, antennas 6A to 6C, pre-regulator circuits 11 and 12, and a DC power source 50.

The pre-regulator circuit 12 is an example of a third converter circuit and a second pre-regulator circuit, and is configured to convert an input voltage into a regulating voltage (an example of a second regulating voltage). The pre-regulator circuit 12 can output the regulating voltage to the switched-capacitor circuit 20, and can also output the regulating voltage to the power amplifier 2C without passing through the switched-capacitor circuit 20.

The power amplifier 2C is an example of a third power amplifier, which is connected between the RFIC 5 and the filter 3C. The power amplifier 2C is also connected to the pre-regulator circuit 12, and can receive a power supply voltage V_{APT2} based on the APT mode. The power amplifier 2C can use the power supply voltage V_{APT2} received from the pre-regulator circuit 12 to amplify an RF signal RF_{C} of a band C received from the RFIC 5. That is, the power amplifier 2C can operate in the APT mode.

The filter 3C is connected between the power amplifier 2C and the antenna 6C. The filter 3C is a band pass filter having a passband including the transmission band of the band C. Note that the filter 3C does not have to be included in the communication device 7B.

As with the bands A and B, the band C is a frequency band for a communication system built using a RAT, and is predefined by a standardizing body or the like. The band C is an example of a third band, which is included in the mid-high band group (1427 to 2690 MHz) or the low band group (698 to 960 MHz) in this embodiment. Note that the band C is not limited to the frequency band included in the mid-high band group or low band group.

The antenna 6C outputs a transmission signal of the band C inputted from the power amplifier 2C through the filter 3C. The antenna 6C does not have to be included in the communication device 7B.

### [2.2 Circuit Configuration of Tracker Circuit 1B]

Next, a circuit configuration of the tracker circuit 1B will be described with reference to Figs. 10 and 3.

The tracker circuit 1B includes a switched-capacitor circuit 20, a supply modulator 31, a filter circuit 41, a digital control circuit 60, an input switch circuit 70, and external connection terminals 101 to 103.

The external connection terminal 101 is an example of a first external connection terminal, which is connected to the pre-regulator circuit 11 outside the tracker circuit 1B and is connected to the input switch circuit 70 inside the tracker circuit 1B.

The external connection terminal 103 is an example of a third external connection terminal, and is a terminal that represents a plurality of external connection terminals, as with the external connection terminal 101. The external connection terminal 103 is connected to the pre-regulator circuit 12 outside the tracker circuit 1B and is connected to the input switch circuit 70 inside the tracker circuit 1B. The external connection terminal 103 is a terminal for receiving the regulating voltage (an example of the second regulating voltage) from the pre-regulator circuit 12.

The input switch circuit 70 is configured to switch the connection of the switched-capacitor circuit 20 between the pre-regulator circuits 11 and 12. For example, the input switch circuit 70 can be configured as a single-pole double-throw (SPDT) type switch circuit. Specifically, the input switch circuit 70 includes switches S76 and S77.

The switch S76 is an example of a first switch, which is connected between the external connection terminal 101 and an input terminal of the switched-capacitor circuit 20. That is, one end of the switch S76 is connected to the external connection terminal 101, and the other end of the switch S76 is connected to the input terminal of the switched-capacitor circuit 20.

The switch S77 is an example of a second switch, which is connected between the external connection terminal 103 and the input terminal of the switched-capacitor circuit 20. That is, one end of the switch S77 is connected to the external connection terminal 103, and the other end of the switch S77 is connected to the input terminal of the switched-capacitor circuit 20.

### [2.3 Effects and the like]

As described above, the tracker circuit 1B according to this embodiment may be further connected to the pre-regulator circuit 12 configured to convert the input voltage into the regulating voltage. The switched-capacitor circuit 20 may also be configured to generate a plurality of discrete voltages based on the regulating voltage. The pre-regulator circuit 12 may be configured to output the regulating voltage to the switched-capacitor circuit 20 and to output the regulating voltage to the power amplifier 2C without passing through the switched-capacitor circuit 20. The tracker circuit 1B may further include the input switch circuit 70 configured to switch the connection of the switched-capacitor circuit 20 between the pre-regulator circuits 11 and 12.

From another perspective, the tracker circuit 1B according to this embodiment may further include: the external connection terminal 103 connected to the pre-regulator circuit 12 including the power inductor L71; the switch S76 connected between the external connection terminal 101 and the input terminal 120; and the switch S77 connected between the external connection terminal 103 and the input terminal 120. The pre-regulator circuit 12 may also be connected to the power amplifier 2C without passing through the switched-capacitor circuit 20 and the supply modulator 31.

This allows the connection of the switched-capacitor circuit 20 to be switched between the pre-regulator circuits 11 and 12, thus making it possible to switch between the power amplifiers 2B and 2C to be operated simultaneously with the power amplifier 2A to which the power supply voltage is supplied from the tracker circuit 1B. That is, when the pre-regulator circuit 11 is connected to the switched-capacitor circuit 20, the power supply voltage can be simultaneously supplied to the power amplifiers 2A and 2C. When the pre-regulator circuit 12 is connected to the switched-capacitor circuit 20, on the other hand, the power supply voltage can be simultaneously supplied to the power amplifiers 2A and 2B.

For example, in the tracker circuit 1B according to this embodiment, the power amplifier 2C may be configured to operate in the APT mode.

This makes it possible to improve the power-added efficiency by using the APT mode in the power amplifier 2C.

For example, in the tracker circuit 1B according to this embodiment, the power amplifier 2C may be configured to amplify a transmission signal of the band C included in the range of 1427 to 2690 MHz or the range of 698 to 960 MHz.

This makes it possible to use the digital ET mode for the frequency band of the ultra-high band group that allows a higher maximum output power. The power-added efficiency can thus be improved more effectively.

### (Embodiment 3)

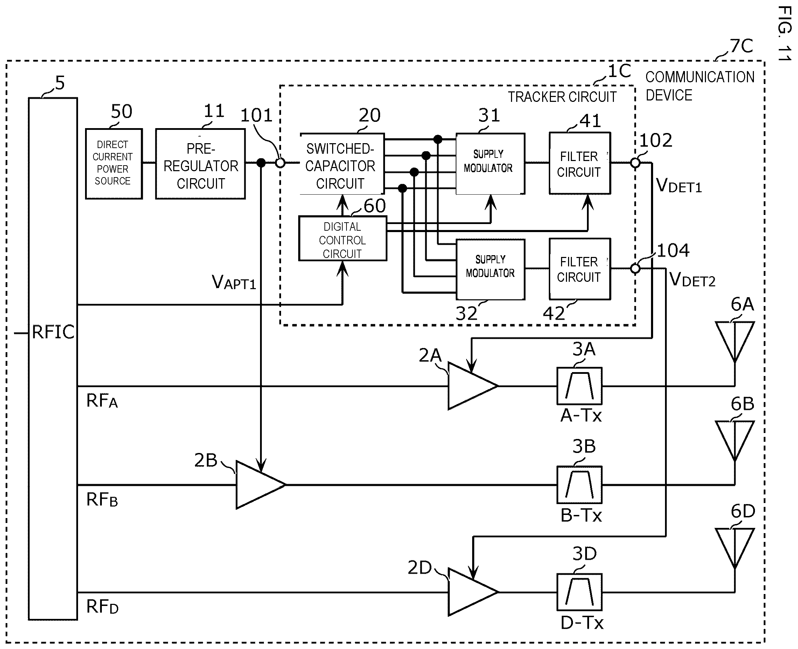

Next, Embodiment 3 will be described. A tracker circuit 1C according to this embodiment is mainly different from the tracker circuit 1A according to Embodiment 1 in that the tracker circuit 1C includes a plurality of supply modulators and can simultaneously supply different power supply voltages to a plurality of power amplifiers. This embodiment will be described below with reference to Fig. 11, focusing on differences from Embodiments 1 and 2. Fig. 11 is a circuit configuration diagram of a communication device 7C according to this embodiment.

Note that Fig. 11 illustrates an exemplary circuit configuration. The communication device 7C and the tracker circuit 1C can be implemented using any of a wide variety of circuit implementations and circuit techniques. Therefore, the description of the communication device 7C and the tracker circuit 1C provided below should not be interpreted as being limited thereto.

### [3.1 Circuit Configuration of Communication Device 7C]

First, the communication device 7C according to this embodiment will be described with reference to Fig. 11. The communication device 7C includes the tracker circuit 1C, power amplifiers 2A, 2B, and 2D, filters 3A, 3B, and 3D, an RFIC 5, antennas 6A, 6B, and 6D, a pre-regulator circuit 11, and a DC power source 50.

The power amplifier 2D is an example of a fourth power amplifier, which is connected between the RFIC 5 and the filter 3D. The power amplifier 2D is also connected to the tracker circuit 1C, and can receive a power supply voltage V_{DET2} based on the digital ET mode. The power amplifier 2D can use the power supply voltage V_{DET2} received from the tracker circuit 1C to amplify an RF signal RF_{D} of a band D received from the RFIC 5. That is, the power amplifier 2D can operate in the digital ET mode.

The filter 3D is connected between the power amplifier 2D and the antenna 6D. The filter 3D is a band pass filter having a passband including the transmission band of the band D. Note that the filter 3D does not have to be included in the communication device 7C.

As with the bands A to C, the band D is a frequency band for a communication system built using a RAT, and is predefined by a standardizing body or the like. The band D is an example of a fourth band, which is included in the ultra-high band group (3300 to 5000 MHzMHz) in this embodiment. Note that the band D is not limited to the frequency band included in the ultra-high band group.

The antenna 6D outputs a transmission signal of the band D inputted from the power amplifier 2D through the filter 3D. The antenna 6D does not have to be included in the communication device 7C.

### [3.2 Circuit Configuration of Tracker Circuit 1C]

Next, a circuit configuration of the tracker circuit 1C will be described with reference to Figs. 11 and 3.

The tracker circuit 1C includes a switched-capacitor circuit 20, supply modulators 31 and 32, filter circuits 41 and 42, a digital control circuit 60, and external connection terminals 101, 102, and 104.

The external connection terminal 104 is an example of a fourth external connection terminal, and is a terminal that represents a plurality of external connection terminals, as with the external connection terminal 101. The external connection terminal 104 is connected to the power amplifier 2D outside the tracker circuit 1C and is connected to the filter circuit 42 inside the tracker circuit 1C. The external connection terminal 104 is a terminal for supplying the power supply voltage V_{DET2} to the power amplifier 2D.

The supply modulator 32 is an example of a second supply modulator, which is configured to selectively output at least one of a plurality of discrete voltages generated by the switched-capacitor circuit 20 to the power amplifier 2D. That is, the supply modulator 32 can select at least one voltage from among the plurality of discrete voltages and output the selected at least one voltage to the power amplifier 2D. In this event, the supply modulator 32 can discretely change over time the level of the voltage outputted to the power amplifier 2D by repeating the selection operation. Such a supply modulator 32 has the same circuit configuration as that of the supply modulator 31, and is controlled based on a digital control signal.

The filter circuit 42 is connected between the supply modulator 32 and the power amplifier 2D, and is configured to attenuate noise components from signals (a plurality of discrete voltages) from the supply modulator 32. Such the filter circuit 42 has the same circuit configuration as that of the filter circuit 41.

### [3.3 Effects and the like]

As described above, the tracker circuit 1C according to this embodiment may further include the supply modulator 32 configured to selectively output at least one of the plurality of discrete voltages to the power amplifier 2D.

From another perspective, the tracker circuit 1C according to this embodiment may further include: the external connection terminal 104 connected to the power amplifier 2D; and the supply modulator 32 including the input terminals 131 to 134 connected to the output terminals 121 to 124, respectively, and the output terminal 130 connected to the external connection terminal 104.

With this configuration, since the tracker circuit 1C includes the supply modulators 31 and 32, different power supply voltages V_{DET1} and V_{DET2} can be simultaneously supplied from the tracker circuit 1C to the two power amplifiers 2A and 2D. In this case, the pre-regulator circuit 11 and the switched-capacitor circuit 20 can be shared by the two power amplifiers 2A and 2D, making it possible to contribute to reduction in the number of components and size reduction of the communication device 7C.

For example, in the tracker circuit 1C according to this embodiment, the power amplifier 2D may be configured to operate in the digital ET mode.

This makes it possible to improve the power-added efficiency by using the digital ET mode in the power amplifier 2D.

For example, in the tracker circuit 1C according to this embodiment, the power amplifier 2D may be configured to amplify a transmission signal of the band D included in the range of 3300 to 5000 MHz.

This makes it possible to use the digital ET mode for the frequency band of the ultra-high band group that allows a higher maximum output power. The power-added efficiency can thus be improved more effectively.

### (Other Embodiments)

The tracker circuit, the radio frequency communication system, and the tracking method according to the present invention have been described above based on the embodiments, but the tracker circuit, the radio frequency communication system, and the tracking method according to the present invention are not limited to the above embodiments. The present invention also includes other embodiments realized by combining any of the components in the above embodiments, modifications obtained by applying various modifications to the above embodiments that can be conceived by those skilled in the art without departing from the spirit of the present invention, and various devices including the above tracker circuit.

For example, in the circuit configuration of the various circuits according to the above embodiments, other circuit elements, wiring, and the like may be inserted between the paths connecting the circuit elements and signal paths disclosed in the drawings. For example, an impedance matching circuit may be inserted between the power amplifier 2A and the filter 3A.

In the above embodiments, a plurality of discrete voltages are supplied to the supply modulator from the switched-capacitor circuit, but the present invention is not limited thereto. For example, a plurality of voltages may be supplied to the supply modulator from a plurality of DC-to-DC converters. When the voltage levels of the plurality of discrete voltages are equally spaced, it is preferable to use a switched-capacitor circuit, which is effective in reducing the size of the tracker module.

In the above embodiments, four discrete voltages are supplied to the power amplifier, but the number of the discrete voltages is not limited to four. For example, when the plurality of discrete voltages include at least a voltage corresponding to the maximum output power and a voltage corresponding to the most frequently occurring output power, the power-added efficiency can be improved.

The plurality of circuit components of the tracker circuit 1A are arranged on the main surface 90a of the module laminate 90 in Embodiment 1 described above, but may be arranged separately on both the main surfaces 90a and 90b. In this case, the integrated circuit 80, for example, may be disposed on the main surface 90b.

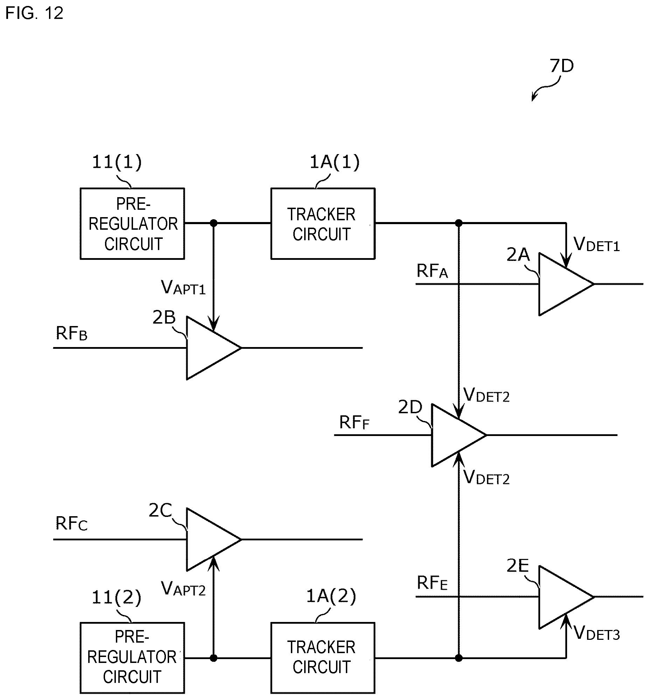

In Embodiment 3 described above, one tracker circuit supplies a power supply voltage based on the digital ET mode to a plurality of power amplifiers, but more than one tracker circuit may be used to supply the power supply voltage based on the digital ET mode to the plurality of power amplifiers. For example, as illustrated in Fig. 12, the communication device 7D may include two tracker circuits 1A, power amplifiers 2A to 2E, and two pre-regulator circuits 11. In this case, since both of the two tracker circuits 1A can supply a power supply voltage V_{DET2} to the power amplifier 2D, the power supply voltage can be supplied simultaneously in the following combination. (1) The tracker circuit 1A (1) supplies the power supply voltage V_{DET1} for amplifying the RF signal RF_{A} of the band A to the power amplifier 2A, and the tracker circuit 1A (2) supplies the power supply voltage V_{DET2} for amplifying the RF signal RF_{D} of the band D to the power amplifier 2D. This allows both the power amplifiers 2A and 2D to operate simultaneously in the digital ET mode. That is, the power-added efficiency can be improved in the simultaneous transmission of the bands A and D. (2) The tracker circuit 1A (1) supplies the power supply voltage V_{DET1} for amplifying the RF signal RF_{A} of the band A to the power amplifier 2A, and the tracker circuit 1A (2) supplies a power supply voltage V_{DET3} for amplifying an RF signal RF_{E} of the band E to the power amplifier 2E. This allows both the power amplifiers 2A and 2E to operate simultaneously in the digital ET mode. That is, the power-added efficiency can be improved in the simultaneous transmission of the bands A and E. (3) The tracker circuit 1A (1) supplies the power supply voltage V_{DET1} for amplifying the RF signal RF_{A} of the band A to the power amplifier 2A, and the pre-regulator circuit 11 (2) supplies the power supply voltage V_{APT2} for amplifying the RF signal RF_{C} of the band C to the power amplifier 2C. This allows the power amplifier 2A to operate in the digital ET mode and the power amplifier 2C to operate in the APT mode simultaneously. That is, the power-added efficiency can be improved in the simultaneous transmission of the bands A and C. (4) The tracker circuit 1A (1) supplies the power supply voltage V_{DET2} for amplifying the RF signal RF_{D} of the band D to the power amplifier 2D, and the tracker circuit 1A (2) supplies the power supply voltage V_{DET3} for amplifying the RF signal RF_{E} of the band E to the power amplifier 2E. This allows both the power amplifiers 2D and 2E to operate simultaneously in the digital ET mode. That is, the power-added efficiency can be improved in the simultaneous transmission of the bands D and E. (5) The tracker circuit 1A (1) supplies the power supply voltage V_{DET2} for amplifying the RF signal RF_{D} of the band D to the power amplifier 2D, and the pre-regulator circuit 11 (2) supplies the power supply voltage V_{APT2} for amplifying the RF signal RF_{C} of the band C to the power amplifier 2C. This allows the power amplifier 2D to operate in the digital ET mode and the power amplifier 2C to operate in the APT mode simultaneously. That is, the power-added efficiency can be improved in the simultaneous transmission of the bands C and D. (6) The pre-regulator circuit 11 (1) supplies the power supply voltage V_{APT1} for amplifying the RF signal RF_{B} of the band B to the power amplifier 2B, and the tracker circuit 1A (2) supplies the power supply voltage V_{DET2} for amplifying the RF signal RF_{D} of the band D to the power amplifier 2D. This allows the power amplifier 2B to operate in the APT mode and the power amplifier 2D to operate in the digital ET mode simultaneously. That is, the power-added efficiency can be improved in the simultaneous transmission of the bands B and D. (7) The pre-regulator circuit 11(1) supplies the power supply voltage V_{APT1} for amplifying the RF signal RF_{B} of the band B to the power amplifier 2B, and the tracker circuit 1A (2) supplies the power supply voltage V_{DET3} for amplifying the RF signal RF_{E} of the band E to the power amplifier 2E. This allows the power amplifier 2B to operate in the APT mode and the power amplifier 2E to operate in the digital ET mode simultaneously. That is, the power-added efficiency can be improved in the simultaneous transmission of the bands B and E. (8) The pre-regulator circuit 11 (1) supplies the power supply voltage V_{APT1} for amplifying the RF signal RF_{B} of the band B to the power amplifier 2B, and the pre-regulator circuit 11 (2) supplies the power supply voltage V_{APT2} for amplifying the RF signal RF_{C} of the band C to the power amplifier 2C. This allows both the power amplifiers 2B and 2C to operate simultaneously in the APT mode. That is, the power-added efficiency can be improved in simultaneous transmission of the bands B and C.

The features of the tracker circuit, the radio frequency communication system, and the tracking method described based on the above embodiments will be described below.

<1> A tracker circuit connected to a first converter circuit configured to convert an input voltage to a first regulating voltage, including:
   a second converter circuit configured to generate a plurality of discrete voltages based on the first regulating voltage; and
   a first supply modulator configured to selectively output at least one of the plurality of discrete voltages to a first power amplifier, in which
   the first converter circuit is configured to output the first regulating voltage to the second converter circuit, and to output the first regulating voltage to a second power amplifier without passing through the second converter circuit.
<2> The tracker circuit according to <1>, in which
   the first power amplifier is configured to operate in a digital envelope tracking mode, and
   the second power amplifier is configured to operate in an average power tracking mode.
<3> The tracker circuit according to <2>, in which
   the first power amplifier is configured to amplify a transmission signal of a first band included in a range of 3300 to 5000 MHz, and
   the second power amplifier is configured to amplify a transmission signal of a second band included in a range of 1427 to 2690 MHz or a range of 698 to 960 MHz.
<4> The tracker circuit according to any one of <1> to <3>, in which
   a distance between the second converter circuit and the first power amplifier is shorter than a distance between the second converter circuit and the second power amplifier.
<5> The tracker circuit according to any one of <1> to <4>, in which
   the first converter circuit, the second converter circuit, and the first power amplifier are disposed on a same substrate, and
   in plan view of the substrate, the second converter circuit is disposed between the first converter circuit and the first power amplifier.
<6> The tracker circuit according to any one of <1> to <5>, in which
   the tracker circuit is further connected to a third converter circuit configured to convert the input voltage into a second regulating voltage,
   the second converter circuit is further configured to generate the plurality of discrete voltages based on the second regulating voltage, and
   the third converter circuit is configured to output the second regulating voltage to the second converter circuit and to output the second regulating voltage to a third power amplifier without passing through the second converter circuit,
   the tracker circuit further including:
      an input switch circuit configured to switch connection of the second converter circuit between the first converter circuit and the third converter circuit.
<7> The tracker circuit according to <6>, in which
   the third power amplifier is configured to operate in an average power tracking mode.
<8> The tracker circuit according to <7>, in which
   the third power amplifier is configured to amplify a transmission signal of a third band included in a range of 1427 to 2690 MHz or a range of 698 to 960 MHz.
<9> The tracker circuit according to any one of <1> to <8>, further including:
   a second supply modulator configured to selectively output at least one of the plurality of discrete voltages to a fourth power amplifier.
<10> The tracker circuit according to <9>, in which
   the fourth power amplifier is configured to operate in a digital envelope tracking mode.
<11> The tracker circuit according to <10>, in which
   the fourth power amplifier is configured to amplify a transmission signal of a fourth band included in a range of 3300 to 5000 MHz.
<12> A radio frequency communication system including:
   the tracker circuit according to any one of <1> to <11>;
   the first converter circuit;
   the first power amplifier; and
   the second power amplifier.
<13> A tracker circuit including:
   a first external connection terminal connected to a first pre-regulator circuit including a first power inductor;
   a second external connection terminal connected to a first power amplifier;
   a switched-capacitor circuit including a first input terminal and a plurality of first output terminals, the first input terminal being connected to the first external connection terminal; and
   a first supply modulator including a plurality of second input terminals and a second output terminal, the plurality of second input terminals being connected to the plurality of first output terminals, the second output terminal being connected to the second external connection terminal, in which
   the first pre-regulator circuit is further connected to a second power amplifier without passing through the switched-capacitor circuit and the first supply modulator.
<14> The tracker circuit according to <13>, in which
   a distance between the switched-capacitor circuit and the first power amplifier is shorter than a distance between the switched-capacitor circuit and the second power amplifier.
<15> The tracker circuit according to <13> or <14>, in which
   the first pre-regulator circuit, the switched-capacitor circuit, and the first power amplifier are disposed on a same substrate, and
   in plan view of the substrate, the switched-capacitor circuit is disposed between the first pre-regulator circuit and the first power amplifier.
<16> The tracker circuit according to any one of <13> to <15>, further including:
   a third external connection terminal connected to a second pre-regulator circuit including a second power inductor;
   a first switch connected between the first external connection terminal and the first input terminal; and
   a second switch connected between the third external connection terminal and the first input terminal, in which
   the second pre-regulator circuit is further connected to a third power amplifier without passing through the switched-capacitor circuit and the first supply modulator.
<17> The tracker circuit according to any one of <13> to <16>, further including:
   a fourth external connection terminal connected to a fourth power amplifier; and
   a second supply modulator including a plurality of third input terminals and a third output terminal, the plurality of third input terminals being connected to the plurality of first output terminals, the third output terminal being connected to the fourth external connection terminal.
<18> A radio frequency communication system including:
   the tracker circuit according to any one of <13> to <17>;
   the first pre-regulator circuit;
   the first power amplifier; and
   the second power amplifier.
<19> A tracking method including:
   converting an input voltage to a regulating voltage using a power inductor;
   generating a plurality of discrete voltages based on the regulating voltage;
   selectively supplying at least one of the plurality of discrete voltages to a first power amplifier; and
   supplying the regulating voltage to a second power amplifier after skipping generation of the plurality of discrete voltages.
<20> The tracking method according to <19>, in which
   the first power amplifier is configured to amplify a first radio frequency signal of a first band in a digital envelope tracking mode,
   the second power amplifier is configured to amplify a second radio frequency signal of a second band in an average power tracking mode,
   when the first band is used for communication, the input voltage is converted, the plurality of discrete voltages are generated, and the plurality of discrete voltages are selectively supplied to the first power amplifier, and
   when the second band is used for communication, the input voltage is converted, the regulating voltage is supplied to the second power amplifier, and the generation of the plurality of discrete voltages is skipped.

### Industrial Applicability

The present invention can be widely used as a tracker circuit that supplies a voltage to a power amplifier in a communication device such as a mobile phone.

### Reference Signs List

1A, 1B, 1C TRACKER CIRCUIT
2A, 2B, 2C, 2D, 2E POWER AMPLIFIER
3A, 3B, 3C, 3D FILTER
5 RFIC
6A, 6B, 6C, 6D ANTENNA
7A, 7B, 7C, 7D COMMUNICATION DEVICE
11, 12 PRE-REGULATOR CIRCUIT
20 SWITCHED-CAPACITOR CIRCUIT
31, 32 SUPPLY MODULATOR
41, 42 FILTER CIRCUIT
50 DIRECT CURRENT (DC) POWER SOURCE
60 DIGITAL CONTROL CIRCUIT
61 FIRST CONTROLLER
62 SECOND CONTROLLER
80 INTEGRATED CIRCUIT
80b SC SWITCH PORTION
80c OS SWITCH PORTION
80d FILTER SWITCH PORTION
90 MODULE LAMINATE
90a, 90b MAIN SURFACE
90e GROUND PLANE
91 RESIN MEMBER
92 SHIELD ELECTRODE LAYER
100 TRACKER MODULE
101, 101a, 101b, 101c, 101d, 102, 103, 104 EXTERNAL CONNECTION TERMINAL
110, 120a, 120b, 120c, 120d, 131, 132, 133, 134 INPUT TERMINAL
111, 112, 113, 114, 121, 122, 123, 124, 130 OUTPUT TERMINAL
150 ELECTRODE
601, 602, 603, 604 CONTROL TERMINAL

## Claims

1. A tracker circuit connected to a first converter circuit configured to convert an input voltage to a first regulating voltage, comprising:
a second converter circuit configured to generate a plurality of discrete voltages based on the first regulating voltage; and
a first supply modulator configured to selectively output at least one of the plurality of discrete voltages to a first power amplifier, wherein
the first converter circuit is configured to output the first regulating voltage to the second converter circuit, and to output the first regulating voltage to a second power amplifier without passing through the second converter circuit.

2. The tracker circuit according to claim 1, wherein
the first power amplifier is configured to operate in a digital envelope tracking mode, and
the second power amplifier is configured to operate in an average power tracking mode.

3. The tracker circuit according to claim 2, wherein
the first power amplifier is configured to amplify a transmission signal of a first band included in a range of 3300 to 5000 MHz, and
the second power amplifier is configured to amplify a transmission signal of a second band included in a range of 1427 to 2690 MHz or a range of 698 to 960 MHz.

4. The tracker circuit according to any one of claims 1 to 3, wherein
a distance between the second converter circuit and the first power amplifier is shorter than a distance between the second converter circuit and the second power amplifier.

5. The tracker circuit according to any one of claims 1 to 4, wherein
the first converter circuit, the second converter circuit, and the first power amplifier are disposed on a same substrate, and
in plan view of the substrate, the second converter circuit is disposed between the first converter circuit and the first power amplifier.

6. The tracker circuit according to any one of claims 1 to 5, wherein
the tracker circuit is further connected to a third converter circuit configured to convert the input voltage into a second regulating voltage,
the second converter circuit is further configured to generate the plurality of discrete voltages based on the second regulating voltage, and
the third converter circuit is configured to output the second regulating voltage to the second converter circuit and to output the second regulating voltage to a third power amplifier without passing through the second converter circuit,
the tracker circuit further comprising:
an input switch circuit configured to switch connection of the second converter circuit between the first converter circuit and the third converter circuit.

7. The tracker circuit according to claim 6, wherein
the third power amplifier is configured to operate in an average power tracking mode.

8. The tracker circuit according to claim 7, wherein
the third power amplifier is configured to amplify a transmission signal of a third band included in a range of 1427 to 2690 MHz or a range of 698 to 960 MHz.

9. The tracker circuit according to any one of claims 1 to 8, further comprising:
a second supply modulator configured to selectively output at least one of the plurality of discrete voltages to a fourth power amplifier.

10. The tracker circuit according to claim 9, wherein
the fourth power amplifier is configured to operate in a digital envelope tracking mode.

11. The tracker circuit according to claim 10, wherein
the fourth power amplifier is configured to amplify a transmission signal of a fourth band included in a range of 3300 to 5000 MHz.

12. A radio frequency communication system comprising:
the tracker circuit according to any one of claims 1 to 11;
the first converter circuit;
the first power amplifier; and
the second power amplifier.

13. A tracker circuit comprising:
a first external connection terminal connected to a first pre-regulator circuit including a first power inductor;
a second external connection terminal connected to a first power amplifier;
a switched-capacitor circuit including a first input terminal and a plurality of first output terminals, the first input terminal being connected to the first external connection terminal; and
a first supply modulator including a plurality of second input terminals and a second output terminal, the plurality of second input terminals being connected to the plurality of first output terminals, the second output terminal being connected to the second external connection terminal, wherein
the first pre-regulator circuit is further connected to a second power amplifier without passing through the switched-capacitor circuit and the first supply modulator.

14. The tracker circuit according to claim 13, wherein
a distance between the switched-capacitor circuit and the first power amplifier is shorter than a distance between the switched-capacitor circuit and the second power amplifier.

15. The tracker circuit according to claim 13 or 14, wherein
the first pre-regulator circuit, the switched-capacitor circuit, and the first power amplifier are disposed on a same substrate, and
in plan view of the substrate, the switched-capacitor circuit is disposed between the first pre-regulator circuit and the first power amplifier.

16. The tracker circuit according to any one of claims 13 to 15, further comprising:
a third external connection terminal connected to a second pre-regulator circuit including a second power inductor;
a first switch connected between the first external connection terminal and the first input terminal; and
a second switch connected between the third external connection terminal and the first input terminal, wherein
the second pre-regulator circuit is further connected to a third power amplifier without passing through the switched-capacitor circuit and the first supply modulator.

17. The tracker circuit according to any one of claims 13 to 16, further comprising:
a fourth external connection terminal connected to a fourth power amplifier; and
a second supply modulator including a plurality of third input terminals and a third output terminal, the plurality of third input terminals being connected to the plurality of first output terminals, the third output terminal being connected to the fourth external connection terminal.

18. A radio frequency communication system comprising:
the tracker circuit according to any one of claims 13 to 17;
the first pre-regulator circuit;
the first power amplifier; and
the second power amplifier.

19. A tracking method comprising:
converting an input voltage to a regulating voltage using a power inductor;
generating a plurality of discrete voltages based on the regulating voltage;
selectively supplying at least one of the plurality of discrete voltages to a first power amplifier; and
supplying the regulating voltage to a second power amplifier after skipping generation of the plurality of discrete voltages.

20. The tracking method according to claim 19, wherein
the first power amplifier is configured to amplify a first radio frequency signal of a first band in a digital envelope tracking mode,
the second power amplifier is configured to amplify a second radio frequency signal of a second band in an average power tracking mode,
when the first band is used for communication, the input voltage is converted, the plurality of discrete voltages are generated, and the plurality of discrete voltages are selectively supplied to the first power amplifier, and
when the second band is used for communication, the input voltage is converted, the regulating voltage is supplied to the second power amplifier, and the generation of the plurality of discrete voltages is skipped.
